(19) **Europäisches Patentamt**
**European Patent Office**
**Office européen des brevets**

(11) **EP 1 668 422 B1**

(12) **EUROPÄISCHE PATENTSCHRIFT**

(45) Veröffentlichungstag und Bekanntmachung des Hinweises auf die Patenterteilung:
**09.11.2011 Patentblatt 2011/45**

(21) Anmeldenummer: **04765272.2**

(22) Anmeldetag: **16.09.2004**

(51) Int Cl.:
***G03F 7/20*** *(2006.01)*

(86) Internationale Anmeldenummer:
**PCT/EP2004/010371**

(87) Internationale Veröffentlichungsnummer:
**WO 2005/038340 (28.04.2005 Gazette 2005/17)**

(54) **LITHOGRAFIEBELICHTUNGSEINRICHTUNG**

LITHOGRAPHY ILLUMINATION DEVICE

DISPOSITIF D'ECLAIRAGE POUR LA LITHOGRAPHIE

(84) Benannte Vertragsstaaten:
**AT BE BG CH CY CZ DE DK EE ES FI FR GB GR HU IE IT LI LU MC NL PL PT RO SE SI SK TR**

(30) Priorität: **29.09.2003 DE 10346201**

(43) Veröffentlichungstag der Anmeldung:
**14.06.2006 Patentblatt 2006/24**

(73) Patentinhaber: **KLEO Halbleitertechnik GmbH 88069 Tettnang (DE)**

(72) Erfinder:
• **OPOWER, Hans**
**82152 Krailling (DE)**
• **SCHARL, Stefan**
**88142 Wasserburg (DE)**

(74) Vertreter: **Hoeger, Stellrecht & Partner Patentanwälte**
**Uhlandstrasse 14c**
**70182 Stuttgart (DE)**

(56) Entgegenhaltungen:
**EP-A- 1 319 984     WO-A-00/72092**

• **PATENT ABSTRACTS OF JAPAN Bd. 2000, Nr. 20, 10. Juli 2001 (2001-07-10) -& JP 2001 066783 A (AGENCY OF IND SCIENCE & TECHNOL; NAKANO TAKASHI; KUWABARA MASASHI; TOM), 16. März 2001 (2001-03-16) -& US 6 692 894 B1 (NAKANO TAKASHI ET AL) 17. Februar 2004 (2004-02-17)**
• **ROSTAMI A ET AL: "A proposal for high-resolution photolithography using optical limiters" LASER PHYSICS MAIK NAUKA/ INTERPERIODICA PUBLISHING RUSSIA, Bd. 14, Nr. 6, 11. August 2004 (2004-08-11), Seiten 892-896, XP002323558 ISSN: 1054-660X**

**Beschreibung**

Die Erfindung betrifft eine Lithografiebelichtungseinrichtung zum Herstellen von sich in einer Fläche erstreckenden belichteten Strukturen in einer lichtempfindlichen Schicht, mit einer Aufnahme für die lichtempfindliche Schicht, mit einer Belichtungseinheit umfassend mehrere Laserstrahlungsquellen, eine den Laserstrahlungsquellen zugeordnete Fokussierungsoptik für die aus den jeweiligen Laserstrahlungsquellen austretende Laserstrahlung, welche aus der Laserstrahlung jeder der Laserstrahlungsquellen einen in der lichtempfindlichen Schicht wirksamen Belichtungsfleck mit einer festgelegten Ausdehnung quer zu einer Belichtungsbewegungsrichtung erzeugt, mit einer Bewegungseinheit zur Erzeugung einer Relativbewegung zwischen der Fokussierungsoptik und der Aufnahme in der Belichtungsbewegungsrichtung und mit einer Steuerung zur Steuerung von Intensität und Lage der Belichtungsflecken relativ zur lichtempfindlichen Schicht derart, daß mittels der Belichtungsflecken eine Vielzahl von in der lichtempfindlichen Schicht eindringenden Umwandlungsbereichen erzeugbar ist, in denen das Material der lichtempfindlichen Schicht von einem Ausgangszustand in einen belichteten Zustand umgewandelt ist und die zusammen die belichtete Struktur ergeben.

Eine derartige Lithografiebelichtungseinrichtungen ist aus der EP 1 319 984 bekannt.

Bei Lithografiebelichtungseinrichtungen besteht jedoch stets die Aufgabe, die Ausdehnung des Belichtungsflecks möglichst präzise zu gestalten, um somit möglichst präzise strukturierte belichtete Strukturen herstellen zu können.

Diese Aufgabe wird bei einer Lithografiebelichtungseinrichtung der eingangs beschriebenen Art erfindungsgemäß dadurch gelöst, daß die Fokussierungsoptik eine Endlinse aufweist, die nahe der lichtempfindlichen Schicht Foki der aus jeder der Laserstrahlungsquellen austretenden Laserstrahlung erzeugt, daß sich zur Erzeugung der Belichtungsflecken von den Foki jeweils ein Laserstrahlungsfeld in Richtung der lichtempfindlichen Schicht ausbreitet und eine Leistungsdichte aufweist, welche in dem Umwandlungsbereich in der lichtempfindlichen Schicht zur Ausbildung eines in die lichtempfindliche Schicht eindringenden Kanals mit durch den Kerreffekt gegenüber seiner Umgebung erhöhtem Brechungsindex führt, der das jeweilige Laserstrahlungsfeld räumlich begrenzt führt.

Der Vorteil der erfindungsgemäßen Lösung ist somit darin zu sehen, daß durch die aufgrund des Kerreffekts erreichte Ausbildung des in die lichtempfindliche Schicht in Ausbreitungsrichtung eindringenden Kanals einerseits die Ausdehnung des Laserstrahlungsfelds quer zur Ausbreitungsrichtung reduziert werden kann und außerdem durch die Ausbildung des Kanals mit erhöhtem Brechungsindex eine große Schärfentiefe in der belichteten Struktur erreicht werden kann, die dazu führt, daß die belichtete Struktur sehr präzise Kantenverläufe gegenüber unbelichteten Bereichen der lichtempfindlichen Schicht aufweist, so daß aufgrund der hohen Qualität der Kanten der belichteten Bereiche die Möglichkeit besteht, scharf konturierte belichtete Strukturen herzustellen, die damit auch feiner strukturierbar sind, als die ohne eine derartige Ausbildung eines Kanals mit erhöhtem Brechungsindex erzeugbaren Strukturen.

Insbesondere ist es mit der erfindungsgemäßen Lösung möglich, Ausdehnungen der Belichtungsflecken und der umgewandelten Bereiche zu erhalten, die im Bereich der Wellenlänge oder kleiner als diese sind.

Eine besonders vorteilhafte Lösung sieht dabei vor, daß die Leistungsdichte des Laserstrahlungsfeldes im Umwandlungsbereich der lichtempfindlichen Schicht in einem Bereich von ungefähr $10^6$ bis ungefähr $10^8$ W/cm$^2$ liegt.

Um diese hohe Leistungsdichte zu erreichen sind die unterschiedlichsten Möglichkeiten denkbar. Beispielsweise wäre es denkbar, Laserstrahlungsquellen mit sehr hoher Leistungsdichte zu verwenden.

Eine besonders einfache Lösung sieht vor, daß das jeweilige Laserstrahlungsfeld durch leistungsüberhöhte Kurzpulse gebildet ist.

Vorzugsweise haben die Kurzpulse dabei eine Pulsdauer im Bereich von einigen Nanosekunden oder sind noch kürzer, vorzugsweise im Bereich von Pikosekunden oder noch kürzer.

Hinsichtlich der zur vorteilhaften Ausbildung eines Kanals in der lichtempfindlichen Schicht erforderlichen Erhöhung des Brechungsindex wurden bislang keine näheren Angaben gemacht. So sieht eine besonders günstige Lösung vor, daß der Kerreffekt in dem Kanal zu einer Erhöhung des Brechungsindex gegenüber der Umgebung in der lichtempfindlichen Schicht um mehr als 0,1 führt.

Insbesondere läßt sich bei einer vorteilhaften Ausführungsform mit der erfindungsgemäßen Lithografiebelichtungseinrichtung erreichen, daß der Kanal quer zur Ausbreitungsrichtung der Laserstrahlung eine Querschnittsfläche aufweist, die maximal der Ausdehnung des entsprechenden Fokus in der Endfläche entspricht.

Hinsichtlich der Ausbildung der Endlinse wurden im Zusammenhang mit der bisherigen Erläuterung der einzelnen Ausführungsbeispiele keine näheren Angaben gemacht, außer der, daß diese die nahe der lichtempfindlichen Schicht angeordneten Foki aus der Laserstrahlung erzeugt.

Besonders günstig lassen sich präzise belichtete Strukturen mit einer vorteilhaften Lithografiebelichtungseinrichtung dann herstellen, wenn ergänzend oder alternativ zu den Merkmalen der vorstehend beschriebenen Lithografiebelichtungseinrichtung die Endlinse nahe oder in ihrer lichtempfindlichen Schicht zugewandten Endfläche die Foki erzeugt. In diesem Fall lassen sich Foki mit geringer räumlicher Ausdehnung erzeugen und das sich ausgehend von diesen ausbreitende Laserstrahlungsfeld hat ebenfalls eine geringe räumliche Ausdehnung.

Ferner ist bei einer weiteren bevorzugten Lithografiebelichtungseinrichtung alternativ oder ergänzend zu den bisherigen Ausführungsbeispielen vorgesehen, daß die Endfläche der Endlinse in einem von der Laserstrahlung durchsetzten Bereich eben ist, so daß auch die erzeugten Foki ebenfalls in einer vorzugsweise zur Oberfläche der lichtempfindlichen Schicht parallelen Ebene liegen.

Als besonders geeignet hat sich im Rahmen der erfindungsgemäßen Lösung eine Endlinse erwiesen, die ähnlich eine Hemisphäre oder einer Hyperhemisphäre geformt ist, da sich mit derartigen Formen der Endlinsen besonders günstige räumlich eng begrenzte Foki erzeugen lassen.

Hinsichtlich der genauen Lage der Foki in der Endlinse wurden bislang keine näheren Angaben gemacht. So könnten die Foki in einem unmittelbar an die Endfläche angrenzenden Bereich, jedoch außerhalb des Festkörpers liegen. Eine besonders günstige Ausführungsform sieht vor, daß die Foki im Festkörper der Endlinse und in einem an deren Endfläche angrenzenden Bereich der Endlinse liegen, das heißt insbesondere unmittelbar an die Endfläche selbst angrenzen oder in dieser liegen.

Um die begrenzte Ausdehnung des sich von dem jeweiligen Fokus ausbreitenden Feldes optimal ausnutzen zu können, ist vorgesehen, daß die Endlinse mit ihrer Endfläche in einem Abstand von der lichtempfindlichen Schicht angeordnet ist, der kleiner ist als die Hälfte der Lichtwellenlänge der Laserstrahlung im Vakuum.

Vorzugsweise ist der Abstand derart gering, daß er weniger als ungefähr 50 Nanometer beträgt.

Die lichtempfindliche Schicht kann grundsätzlich jede Art von lichtempfindlicher Schicht sein. Eine besonders vorteilhafte Lösung sieht vor, daß die lichtempfindliche Schicht eine Fotolackschicht ist.

Besonders feine belichtete Strukturen lassen sich bei der erfindungsgemäßen Lösung insbesondere dann erzeugen, wenn der der lichtempfindlichen Schicht zugewandten Endfläche der Fokussierungsoptik eine die räumliche Ausdehnung der Belichtungsflecken auf Dimensionen im Bereich der Wellenlänge der Laserstrahlung oder kleinere Dimensionen reduzierende Blendenstruktur zugeordnet ist.

Eine derartige Blendenstruktur ist vorzugsweise so aufgebaut, daß diese das Laserstrahlungsfeld in Richtung eine Komponente von dessen elektrischem Feld begrenzt.

Vorzugsweise weist eine derartige Blendenstruktur mindestens eine sich in einer Längsrichtung über mehr als eine Wellenlänge der Laserstrahlung erstreckende Durchtrittsöffnung auf.

Vorzugsweise erstreckt sich die Durchtrittsöffnung über ein Vielfaches der Wellenlänge der Laserstrahlung.

Ferner ist vorzugsweise vorgesehen, daß die Durchtrittsöffnung Längsseitenkanten aufweist, die voneinander einen Abstand von einer Wellenlänge der Laserstrahlung oder weniger aufweisen.

Vorzugsweise beträgt der Abstand zwischen den Längsseitenkanten maximal zwei Drittel einer Wellenlänge, noch besser maximal die Hälfte der Wellenlänge.

Die erfindungsgemäße Lithografiebelichtungseinrichtung ist vorzugsweise so ausgebildet, daß bei dieser jeder Belichtungsfleck in einer quer zur Belichtungsbewegungsrichtung verlaufenden Ablenkrichtung bewegbar ist.

In diesem Fall ist vorzugsweise die Blendenstruktur so ausgebildet, daß sich mindestens eine der Durchtrittsöffnungen der Blendenstruktur in der Ablenkrichtung erstreckt.

Eine besonders vorteilhafte Lösung sieht vor, daß die Blendenstruktur eine sich mindestens über einen Bewegungsbereich des jeweiligen Belichtungsflecks in der Ablenkrichtung erstreckende Durchtrittsöffnung aufweist.

Im einfachsten Fall ist dabei das elektrische Feld so ausgerichtet, daß über die gesamte Länge der Durchtrittsöffnung das Laserstrahlungsfeld durch die Durchtrittsöffnung hindurchtreten kann.

Eine andere vorteilhafte Lösung sieht vor, daß die Blendenstruktur in der Ablenkrichtung aufeinanderfolgende Durchlassstellen für das Laserstrahlungsfeld aufweist. Das heißt, daß das Laserstrahlungsfeld nicht über den gesamten Bewegungsbereich des Belichtungsflecks in der Ablenkrichtung die Möglichkeit hat, durch die Blendenstruktur hindurchzutreten, sondern ein Hindurchtreten des Laserstrahlungsfeldes durch die Blendenstruktur nur an bestimmten festgelegten Durchlassstellen notwendig ist.

Eine derartige Lösung hat den Vorteil, daß sich mit dieser allein durch Positionierung der Blendenstruktur relativ zur lichtempfindlichen Schicht die Lage möglicher Belichtungsflecken festlegen läßt und nicht die Notwendigkeit besteht, im Zuge der Bewegung des Belichtungsflecks in Richtung der Ablenkrichtung durch Ein- und Ausschalten der Intensität des Laserstrahlungsfeldes die Lage des zu erzeugenden Belichtungsflecks festzulegen.

Besonders günstig lassen sich derartige Durchlassstellen dadurch erreichen, daß diese durch Kreuzungsstellen zweier schlitzförmiger Durchtrittsöffnungen gebildet sind.

Eine Möglichkeit, eine derartige Vielzahl von Kreuzungsstellen zu realisieren ist die, daß eine der schlitzförmigen Durchtrittsöffnungen sich in der Ablenkrichtung durch die Durchlassstellen hindurch erstreckt.

In diesem Fall wäre es immer noch denkbar, die Durchtrittsöffnungen in ihrer Ausdehnung in Ablenkrichtung zu begrenzen.

Eine besonders günstige Lösung sieht vor, daß sich die in der Ablenkrichtung erstreckende schlitzförmige Durchtrittsöffnung über den gesamten Bewegungsbereich des jeweiligen Laserstrahlungsfeldes in der Ablenkrichtung erstreckt.

Eine alternative Ausführungsform einer erfindungsgemäßen Lösung sieht vor, daß sich die Durchtrittsöffnungen schräg zur Ablenkrichtung erstrecken.

Vorzugsweise sind dabei jeweils zwei Durchtrittsöffnungen so angeordnet, daß sie in einem Winkel von 90° zueinander verlaufen, um im Bereich der Durchtrittsstelle eine möglichst hohe Intensität des hindurchtretenden Laserstrahlungsfeldes zu erreichen.

Hinsichtlich der Ausrichtung des elektrischen Feldes des Laserstrahlungsfeldes der jeweiligen Laserstrahlung ist vorzugsweise vorgesehen, daß sich das elektrische Feld der jeweiligen Laserstrahlung quer zur Längsrichtung der jeweiligen Durchtrittsöffnungen, das heißt schräg oder senkrecht zu dieser, erstreckt.

Ist nur eine Durchtrittsöffnung vorhanden, so ist vorzugsweise vorgesehen, daß das elektrische Feld senkrecht zur Längsrichtung der Durchtrittsöffnung verläuft, Sind mehrere Durchtrittsöffnungen vorhanden, beispielsweise solche, deren Kreuzungsstellen Durchtrittsstellen darstellen sollen, so ist vorzugsweise vorgesehen, daß sich das elektrische Feld möglichst zu der Längsrichtung beider Durchtrittsöffnungen im gleichen Winkel geneigt ist.

Da vorzugsweise die Längsrichtungen zweier Durchtrittsöffnungen im Bereich der Kreuzungsstellungen in einem Winkel von ungefähr 90° zueinander stehen, ist vorzugsweise vorgesehen, daß in diesem Fall das elektrische Feld so ausgerichtet ist, daß es in einem Winkel von ungefähr 45° zu der Längsrichtung jeder der Durchtrittsöffnungen verläuft.

Im Zusammenhang mit der bisherigen Erläuterung einer vorgesehenen Blendenstruktur wurde nicht näher darauf eingegangen, wo die der Fokussierungsoptik zuzuordnende Blendenstruktur anzuordnen ist.

Eine vorteilhafte Ausführungsform sieht dabei vor, daß die Blendenstruktur unmittelbar auf einer Endfläche der Endlinse angeordnet ist.

Eine andere Möglichkeit sieht vor, daß die Blendenstruktur auf einem Träger angeordnet ist, der seinerseits an der Endfläche der Endlinse anliegt.

Vorzugsweise ist dabei der Träger mit einer der Blendenstruktur gegenüberliegenden Seite an der Endfläche der Endlinse angeordnet.

Um Reflexionen beim Übergang zwischen der Endlinse und dem Träger zu vermeiden ist vorzugsweise vorgesehen, daß der Träger brechungsindexangepaßt mit der Endfläche der Endlinse verbunden ist.

Eine derartige brechungsindexangepaßte Verbindung läßt sich beispielsweise dadurch realisieren, daß der Träger klebstofffrei mit der Endfläche der Endlinse verbunden ist.

Eine Möglichkeit einer klebstofffreien Verbindung sieht vor, daß der Träger durch Bonden mit der Endfläche der Endlinse verbunden ist.

Eine andere klebstofffreie Verbindung sieht vor, daß der Träger durch Ansprengen mit der Endfläche der Endlinse verbunden ist.

Schließlich ist es aber auch denkbar, den Träger mittels eine brechungsindexangepaßten Klebstoffes mit der Endlinse zu verbinden.

Hinsichtlich der Ausbildung der Blendenstruktur wurden bislang keine weiteren Angaben gemacht. Die Blendenstruktur kann durch jede Art von Blendenmaterial gebildet sein, das geeignet ist, die Laserstrahlung teilweise zu unterdrücken.

Eine besonders vorteilhafte Lösung sieht vor, daß die Blendenstruktur durch eine Metallschicht gebildet ist, die sich sehr leicht auf eine Oberfläche auftragen und strukturieren läßt.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:

Figur 1     einen grundsätzlichen schematischen Aufbau einer erfindungsgemäßen Lithografiebelichtungseinrichtung;

Figur 2     eine schematische Darstellung von mit der erfindungsgemäßen Lithografiebelichtungseinrichtung herstellbaren belichteten Strukturen und der hierzu eingesetzten Bildflecken;

Figur 3     eine schematische in Blöcken zusammengefaßte Darstellung des Aufbaus einer erfindungsgemäßen Lithografiebelichtungseinrichtung;

Figur 4     eine schematische Darstellung einer Wirkungsweise eines Ausführungsbeispiels einer Ablenkeinheit einer erfindungsgemäßen Lithografiebelichtungseinrichtung;

Figur 5     eine schematische ausschnittsweise Darstellung einer ersten Ausführungsform einer erfindungsgemäßen Belichtungseinheit;

Fig. 6     eine einen Schnitt durch eine Endlinse des ersten Ausführungsbeispiels gemäß Fig. 5;

Fig. 7     eine ausschnittsweise vergrößerte Darstellung des Bereichs X in Fig. 6 bei geringer Leistungsdichte;

Fig. 8     eine ausschnittsweise Darstellung des Bereichs X in Fig. 6 bei hoher Leistungsdichte der Laserstrahlung;

Fig. 9     eine schematische Darstellung einer Intensitätsverteilung im Fokus gemäß Fig. 6 beim ersten Ausführungsbeispiel;

Fig. 10     eine schematische Darstellung einer relativen Anordnung von Fokus und Blendenstruktur bei einem zweiten Ausführungsbeispiel der erfindungsgemäßen Belichtungseinrichtung;

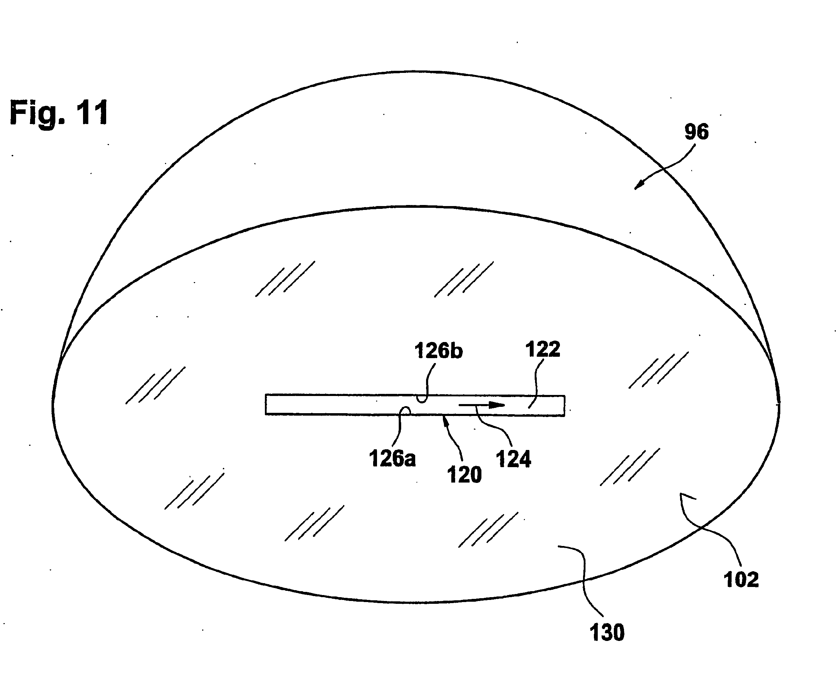

Fig. 11 eine Darstellung der Anordnung der Blendenstruktur bei in dem zweiten Ausführungsbeispiel der erfindungsgemäßen Belichtungseinrichtung auf einer Endfläche der Endlinse;

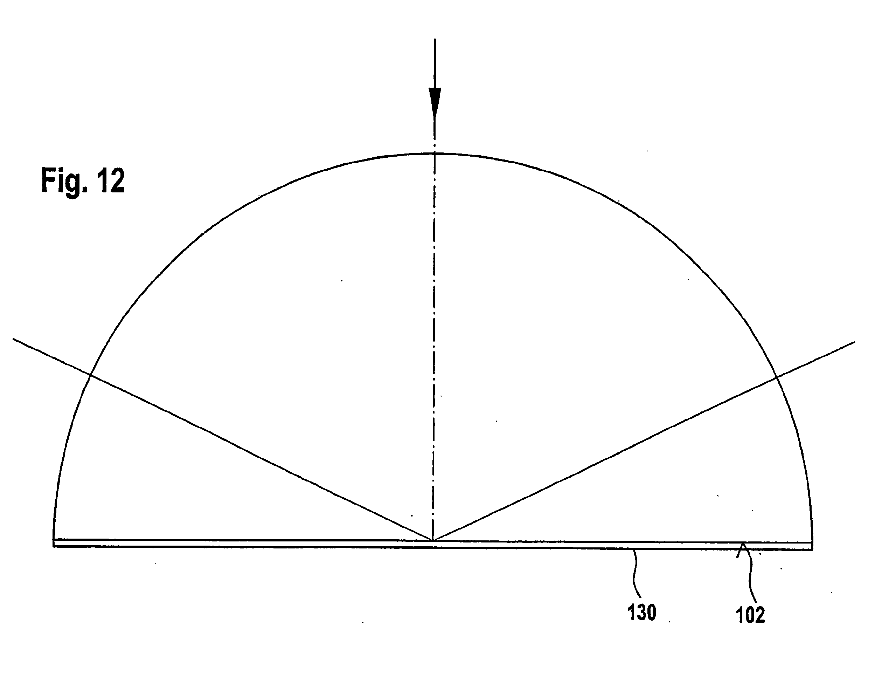

Fig. 12 eine Darstellung ähnlich Fig. 6 des zweiten Ausführungsbeispiels;

Fig. 13 eine Darstellung ähnlich Fig. 6 eines dritten Ausführungsbeispiels;

Fig. 14 eine Darstellung ähnlich Fig. 6 eines vierten Ausführungsbeispiels;

Fig. 15 eine Darstellung ähnlich Fig. 10 eines fünften Ausführungsbeispiels der erfindungsgemäßen Belichtungseinrichtung und

Fig. 16 eine Darstellung ähnlich Fig. 10 eines sechsten Ausführungsbeispiels der erfindungsgemäßen Belichtungseinrichtung.

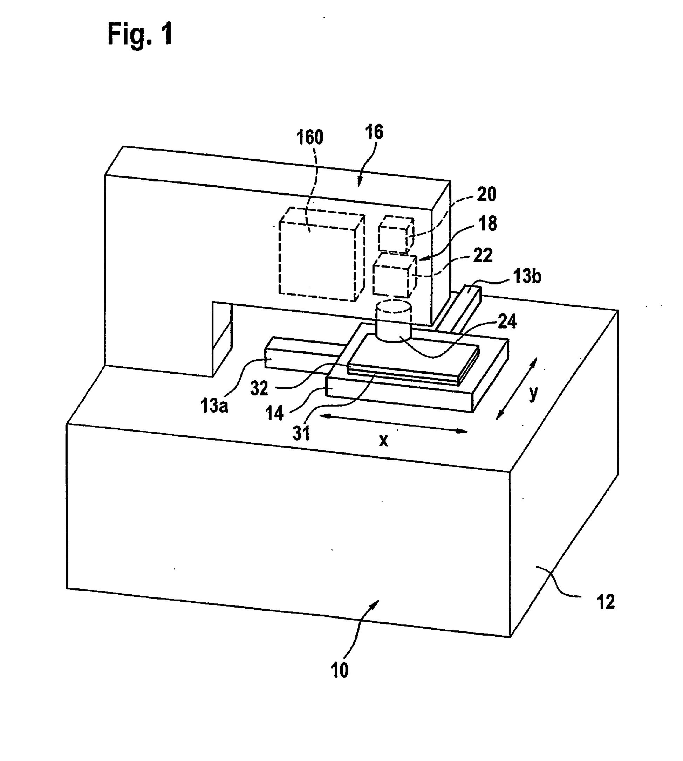

Ein Ausführungsbeispiel einer erfindungsgemäßen Lithografiebelichtungseinrichtung, dargestellt in Figur 1, umfaßt ein als Ganzes mit 10 bezeichnetes Maschinengestell, mit einem Grundkörper 12, an welchem ein Tisch 14 in zwei senkrecht zueinander verlaufenden Richtungen, beispielsweise einer X-Richtung und einer Y-Richtung durch Antriebe 13a, b, bewegbar gelagert ist.

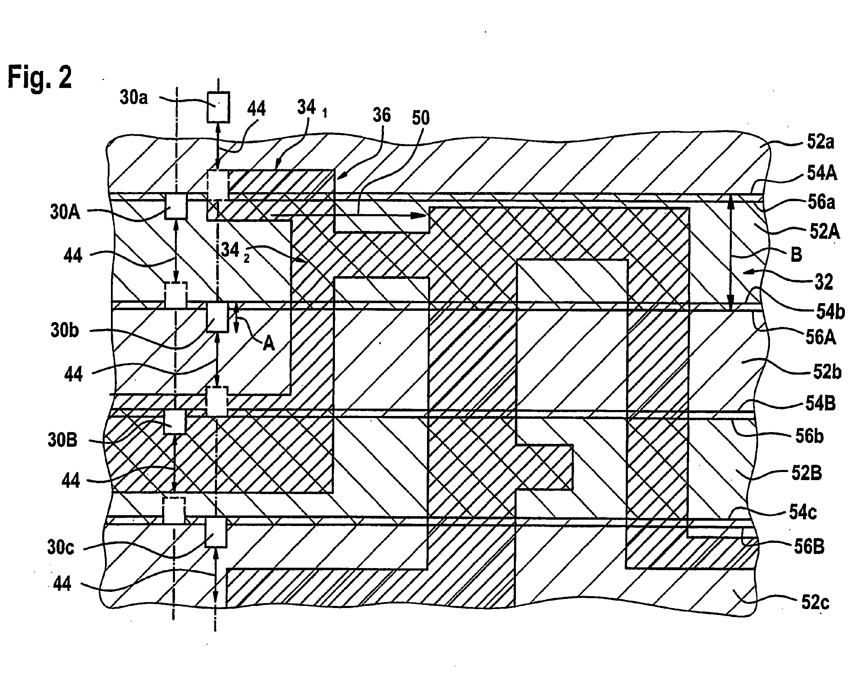

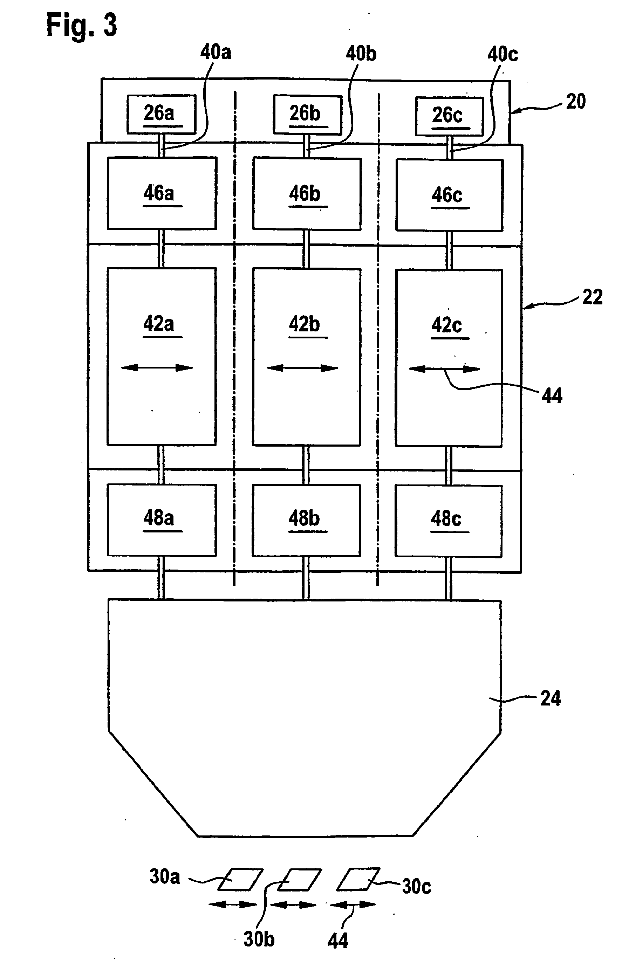

Über dem Grundkörper 12 erhebt sich ein sich über den Tisch 14 und im Abstand von diesem erstreckender Überbau 16, in welchem, wie schematisch in Figur 1 dargestellt, eine Belichtungseinheit 18 angeordnet ist, welche in einer Strahlungsquelleneinheit 20 zusammengefaßt eine Vielzahl von Laserstrahlungsquellen 26 aufweist. An diese Strahlungsquelleneinheit 20 schließt sich eine als Ganzes mit 22 bezeichnete Ablenkeinrichtung und auf diese folgt eine als Ganzes mit 24 bezeichnete Fokussierungsoptik, welche letztlich die Laserstrahlung jeder Laserstrahlungsquelle 26 als Belichtungsfleck 30 auf eine auf dem Tisch 14 angeordnete und auf einem Träger 31 aufgetragene lichtempfindliche Schicht 32, üblicherweise eine Photolackschicht abbildet, um in der lichtempfindlichen Schicht 32 Umwandlungsbereiche 34 zu erzeugen, in welchen die lichtempfindliche Schicht 32 von einem Ausgangszustand in einen Endzustand umgewandelt ist, und welche insgesamt eine belichtete Struktur 36 ergeben (Fig. 2, 3). Auch die Ablenkeinrichtung 22 und die Fokussierungsoptik 24 sind Teil der Belichtungseinheit 18.

Alternativ zum Bewegen des Tisches 14 in X- und Y-Richtung relativ zu einer stationär am Grundkörper 12 angeordneten Belichtungseinheit 18 ist bei einer anderen Ausführungsform der erfindungsgemäßen Lösung vorgesehen, zum Beispiel den Tisch 14 oder die Belichtungseinheit 18 nur in X-Richtung relativ zum Grundkörper 12 zu bewegen und dafür aber auch die Belichtungseinheit 18 bzw. den Tisch 14 relativ zum Grundkörper 12 in Y-Richtung zu bewegen, oder nur die Belichtungseinheit 18 in X- und Y-Richtung zu bewegen und den Tisch 14 stationär am Grundkörper 12 anzuordnen.

Wie nochmals in Figur 3 im Einzelnen, jedoch nach wie vor schematisiert dargestellt, umfaßt die Strahlungsquelleneinheit 22 eine Vielzahl von Laserstrahlungsquellen 26, die beispielsweise Halbleiterdiodenlaser sein können oder Halbleiterlaser mit zugeordneter lichtlinearer optischer Frequenzkonversion, d.h. Frequenzverdopplung, um Laserstrahlung mit möglichst kurzer Wellenlänge, vorzugsweise im blauen oder US Spektralbereich zu erzeugen.

Die von den einzelnen Laserstrahlungsquellen 26 erzeugte Laserstrahlung 40 wird entweder in Form von Freistrahlpropagation oder über Lichtleiter der als Ganzes mit 22 bezeichneten Ablenkeinrichtung zugeführt.

Die Ablenkeinrichtung 22 umfaßt für die Laserstrahlung 40 jeder der Laserstrahlungsquellen 26 jeweils eine Ablenkeinheit 42 mit welcher die Laserstrahlung 40 in einer Ablenkrichtung 44, wie nachfolgend noch im einzelnen beschrieben, ablenkbar ist.

Zwischen jeder der Laserstrahlungsquellen 26 und den entsprechenden Ablenkeinheiten 42 ist noch eine Strahlformungseinheit 46 vorgesehen.

Ferner ist zwischen jeder der Ablenkeinheiten 42 und der Fokussierungsoptik 24 ebenfalls nochmals eine Strahlformungseinheit 48 vorgesehen, welche beispielsweise zur Erzeugung von ungefähr rotationssymmetrischen Laserstrahlungsbündeln vor Eintritt derselben in die Fokussierungsoptik 24 dient.

Die Fokussierungsoptik 24 erzeugt ihrerseits in der lichtempfindlichen Schicht 32 die einzelnen, jeder der Laserstrahlungsquellen 26 zugeordneten Bildflecken 30.

Wie in Figur 2 dargestellt, erfolgt beim Belichten der lichtempfindlichen Schicht 32 ein Bewegen des Tisches 14 mit der darauf angeordneten lichtempfindlichen Schicht 32 in einer Belichtungsbewegungsrichtung 50, die beispielsweise mit der X-Richtung oder der Y-Richtung in Figur 1 zusammenfallen kann oder auch durch Addition einer Bewegung in X- und Y-Richtung entstehen kann.

Ferner verläuft die Belichtungsbewegungsrichtung 50 stets so, daß die Ablenkrichtungen 44, in welche die Laserstrahlung ablenkbar ist, quer zur Belichtungsbewegungsrichtung 50 verlaufen, wobei nicht zwingenderweise ein senkrechter Verlauf erforderlich ist, sondern ebenfalls eine geringfügige Schrägstellung möglich ist.

Durch die Ablenkung der Laserstrahlung 40 in Richtung der Ablenkrichtungen 44 ist auf der lichtempfindlichen Schicht 32 der aus der jeweiligen Laserstrahlung 40 entstehende Belichtungsfleck 30 ebenfalls in der Ablenkrichtung 44 verschiebbar, und zwar zwischen einer in Fig. 2 durchgezogen gezeichneten Extremstellung und einer in Fig. 2 gestrichelt gezeichneten Extremstellung, wobei beide Extremstellungen eine Breite B von Streifenbereichen 52 festlegen, innerhalb welcher mit dem jeweiligen Belichtungsfleck 30 Umwandlungsbereiche 34 in der lichtempfindlichen Schicht 32 erzeugbar sind. Die Breite B entspricht dabei einem Vielfachen einer Ausdehnung A des jeweiligen Belichtungsflecks 30 in der Ablenkrichtung 44.

Die Streifenbereiche 52 sind entweder so angeordnet, dass deren äußeres Ränder 54 und 56 sich geringfügig überlappen, um sicherzustellen, dass die von dem einen der Streifenbereiche 52 zugeordneten Belichtungsfleck 30 erzeugten Umwandlungsbereiche 34 mit den von dem nächstliegenden Streifenbereich 52 zugeordneten Belichtungsfleck 30 erzeugten Umwandlungsbereichen 34 zusammenhängend erzeugbar sind, oder so angeordnet, dass die Streifenbereiche 52 sich nicht überlappen.

Im Fall einer Überlappung ist beispielsweise mit dem Belichtungsfleck 30a in der gestrichelten, unmittelbar an den Rand 56a anschließenden Stellung und dem Belichtungsfleck 30A in seiner unmittelbar an der Rand 54A anschließenden Stellung der Umwandlungsbereich $34_1$ als zusammenhängender Umwandlungsbereich erzeugbar.

Ferner ist beispielsweise sowohl mit dem Belichtungsfleck 34a in einer an den Rand 56a anschließenden Stellung, den Belichtungsflecken 30A und 30b in sämtlichen zwischen den Rändern 54A und 56A sowie 54b und 56b liegenden Stellungen und dem Belichtungsfleck 30B in seinen über etwas mehr als die Hälfte des Streifenbereichs 52B ausgehend von dem Rand 54B liegenden Stellungen der Umwandlungsbereich $34_2$ als zusammenhängender Umwandlungsbereich aufgrund der Überlappung der Streifenbereiche 52a, 52A, 52b und 52B erzeugbar.

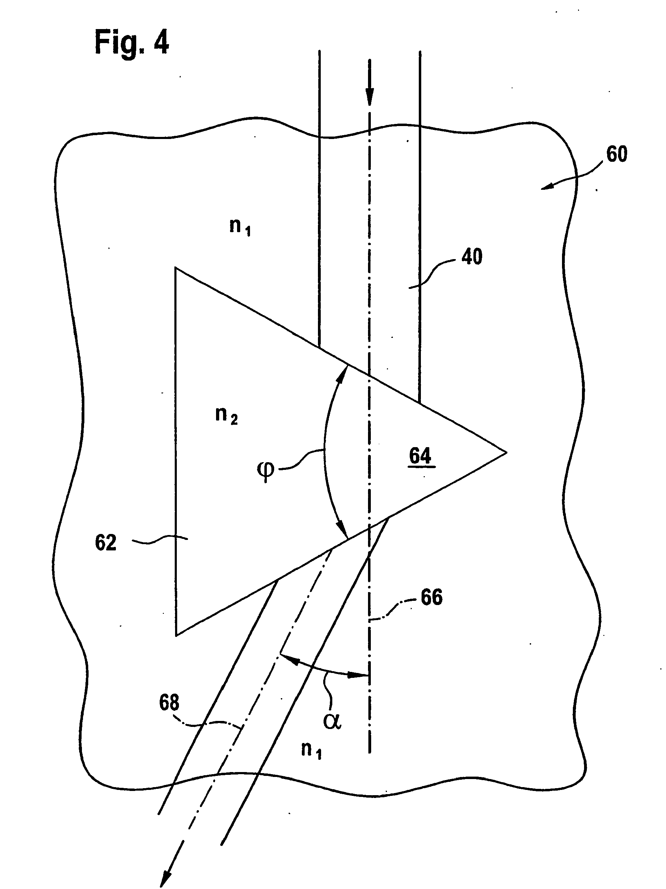

Die einzelnen Ablenkeinheiten 42 arbeiten bei der erfindungsgemäßen Lithografiebelichtungseinrichtung nach folgendem in Fig. 4 schematisch dargestelltem Prinzip:

Die von der jeweiligen Laserstrahlungsquelle 26 kommende Laserstrahlung 40 durchsetzt nach Durchlaufen der Strahlformungseinheit 46, die nachfolgend noch im Einzelnen beschrieben wird, ein erstes Medium 60, welches die Brechzahl $n_1$ aufweist. Von dem ersten Medium 60 geht die Laserstrahlung 40 über in einen, beispielsweise als Prisma oder Linsenhälfte ausgebildeten strahlablenkenden Raumbereich 62, innerhalb von welchem ein zweites Medium 64 eine variable einstellbare Brechzahl $n_2$ aufweist. die größer als $n_1$ ist, und geht wiederum nach Durchsetzen des Raumbereichs 62 in das erste Medium mit der Brechzahl $n_1$ über (Fig.4).

Dadurch erfolgt aufgrund der Brechzahl $n_2$ des zweiten Mediums 64 durch den Raumbereich 62 eine Ablenkung der Laserstrahlung 40 von der ursprünglichen Richtung 66 in eine gegenüber der ursprünglichen Richtung in einem Winkel $\alpha$ verlaufende Austrittsrichtung 68, so daß eine Ablenkung der Laserstrahlung 40 durch den Raumbereich 62 stattfindet.

Der Winkel $\alpha$ hängt dabei davon ab, wie stark sich die Brechzahl $n_2$ des zweiten Mediums 64 von der Brechzahl $n_1$ des ersten Mediums 60 unterscheidet, so daß durch Variation der Brechzahl $n_2$ gleichzeitig auch der Winkel $\alpha$ variabel ist.

Näherungsweise gilt im Fall eines als Prisma ausgebildeten Raumbereichs 62 für kleine Winkel $\alpha$: $\alpha \approx (n_2-n_1)\,\varphi$, wobei $\varphi$ der den prismatischen Raumbereich 62 bestimmende Prismenwinkel ist.

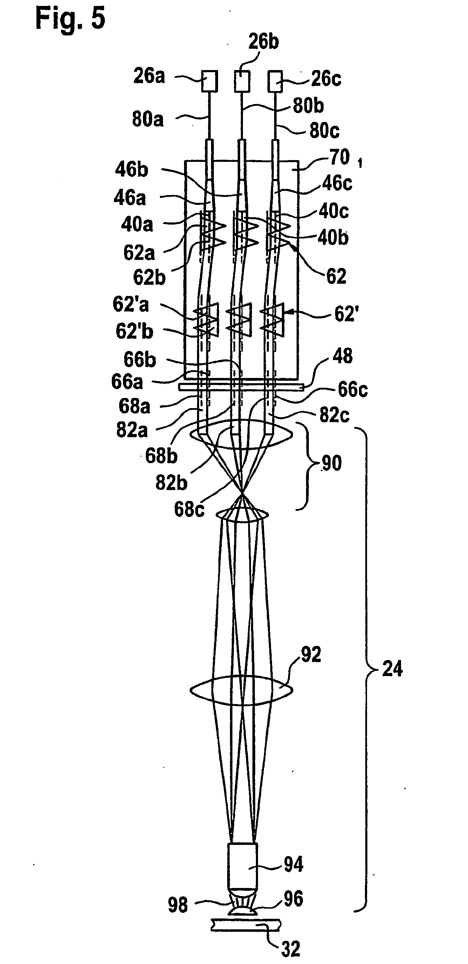

Die Wirksamkeit des Raumbereichs 62 läßt sich noch erhöhen, wenn, wie in Figur 5 dargestellt, mehrere aufeinanderfolgende Raumbereiche 62a, 62b, jeweils aus dem zweiten Medium, eingesetzt werden, durch die die Laserstrahlung 40 nacheinander hindurchläuft, so daß die sich durch jeden einzelnen der Raumbereiche 62a, 62b erzeugte Ablenkung aufsummieren läßt und insgesamt die Austrittsrichtung 68 in einem Winkel $\alpha$ zur ursprünglichen Richtung 66 verläuft, der die Summe der in jedem der Raumbereiche erreichten Ablenkungen darstellt.

Derartige strahlablenkende Raumbereiche 62 sind im Detail in der EP 1 319 984 beschrieben.

Da die Laserstrahlung 40 nach Durchlaufen der Prismenbereiche 62a, 62b in der Austrittsrichtung 68 schräg zur ursprünglichen Richtung 66 verläuft, sind vorzugsweise bei dem ersten Ausführungsbeispiel gemäß Figur 5 zusätzlich komplementär wirkende Raumbereiche 62'a, 62'b vorgesehen, die die Laserstrahlung 40 wieder um einen Winkel $\alpha$ in entgegengesetzter Richtung ablenken, so daß letztlich die Austrittsrichtung 68' nach Durchlaufen der Raumbereiche 62a, 62b und der komplementären Raumbereiche 62'a, 62'b parallel zur ursprünglichen Richtung 66, jedoch um einen Abstand D gegenüber dieser versetzt, verläuft.

Somit kann die sich in Austrittsrichtung 68' ausbreitende Laserstrahlung 40 ohne zusätzliche Maßnahmen aufgrund schrägen Einfalls durch die Fokussierungsoptik 24 in den Belichtungsfleck 30 abgebildet werden.

Bei der in Figur 5 dargestellten Ausführungsform sind aufgrund der Art der Darstellung lediglich die in der Zeichenebene liegenden Elemente dargestellt. So erfolgt die Erzeugung der Laserstrahlung durch die Laserstrahlungsquellen 26a, 26b und 26c und die Laserstrahlung wird über Lichtleiter 80a, 80b und 80c zu der Wellenleiterplatte $70_1$ geführt. In dieser Wellenleiterplatte sind die Strahlformungseinheiten 46a, 46b und 46c für die Laserstrahlung 40a, 40b, 40c aus den einzelnen Laserstrahlungsquellen 26a, 26b und 26c vorgesehen, die die Laserstrahlung 40a, 40c und 40e zu einem sich in der Ablenkrichtung 44 erweiternden Band aufweiten.

Durch die Prismeneinheiten 62 und 62'besteht die Möglichkeit, die Laserstrahlung 40a, 40b und 40c gegenüber der ursprünglichen Richtung 66a, 66b und 66c zu versetzen, beispielsweise in die dargestellten Austrittsrichtungen 68a, 68b und 68c, die untereinander nicht gleich weit in der Ablenkrichtung 44 sein müssen, sondern unterschiedlich sein können.

Die Strahlformungseinheit 48 formt dann aus den Laserstrahlungen 40a, 40b und 40c die Strahlungsbündel 82a, 82b und 82c, die dann in die als Ganzes mit 24 bezeichnete Fokussierungsoptik eintreten.

Die Fokussierungsoptik 24 weist ihrerseits ein Okular 90, eine Tubuslinse 92 und ein Objektiv 94 auf, wobei das Okular beispielsweise zehnfach und das Objektiv 94 beispielsweise fünfzigfach verkleinert.

Vorzugsweise ist dabei die Tubuslinse 92 zwischen dem Okular 90 und dem Objektiv 94 so angeordnet, daß der Abstand jeweils der Brennweite entspricht.

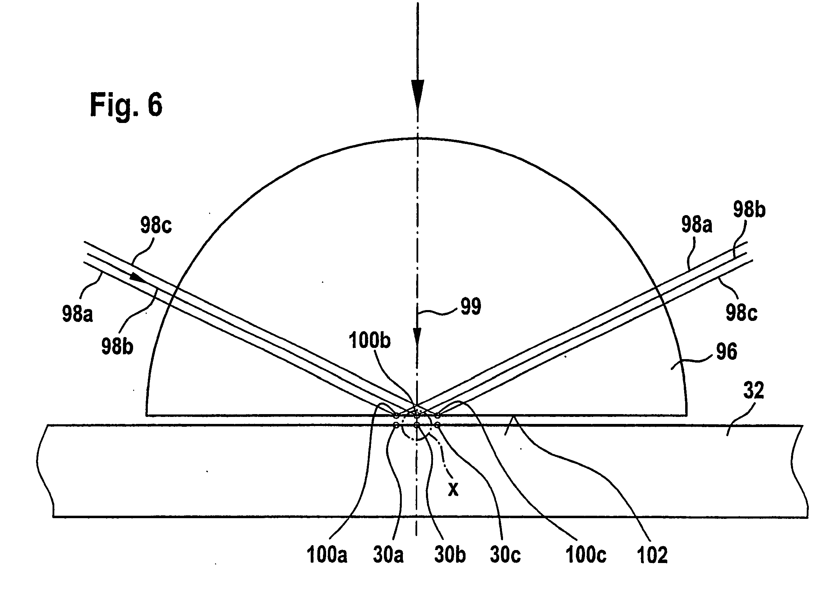

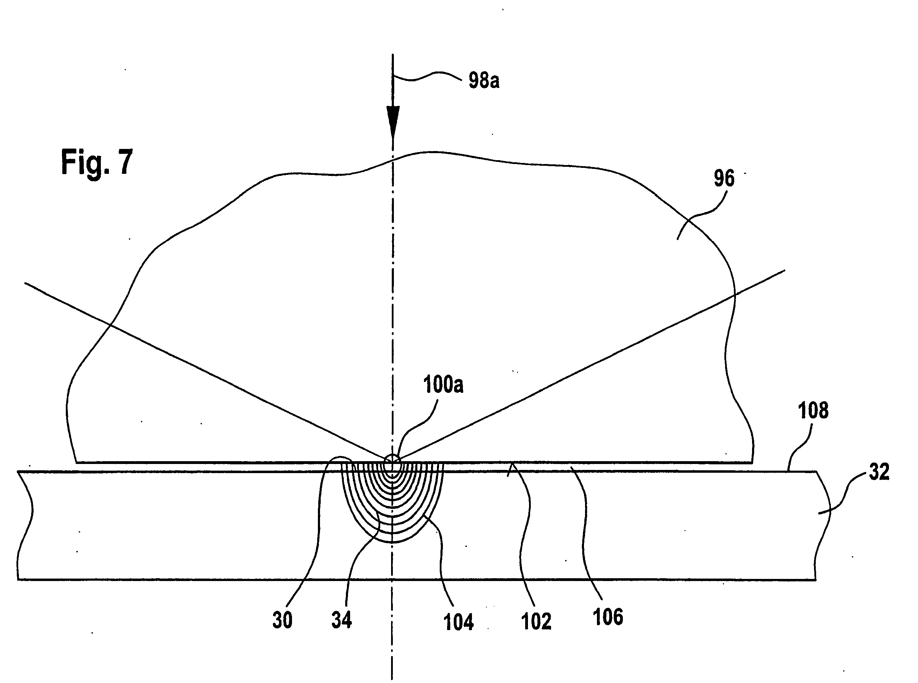

Zwischen dem Objektiv 94 und der lichtempfindlichen Schicht 32 ist noch eine Endlinse 96 der Fokussierungsoptik 24 angeordnet, welche, wie in Fig. 6 dargestellt, die aus dem Objektiv 94 austretende und von diesem fokussierte sowie jeweils einem der Strahlungsbündel 82a, 82b oder 82c entsprechende Laserstrahlung 98, in Fig. 6 beispielsweise die Laserstrahlung 98a, 98b, 98c auf einen entsprechenden Fokus 100a, 100b, 100c innerhalb der Endlinse 96 fokussiert, der jeweils unmittelbar an eine der lichtempfindlichen Schicht 32 zugewandte Endfläche 102 der Endlinse 96 angrenzt, so daß von dem jeweiligen Fokus 100 ausgehend sich ein Laserstrahlungsfeld 104 ausbreitet, welches sich über einen insbesondere weniger als ungefähr 100nm, vorzugsweise weniger als ungefähr 50nm, noch besser größenordnungsmäßig 10nm, breiten Zwischenraum 106 zwischen der Endfläche 102 und der lichtempfindlichen Schicht 32 hinweg in die lichtempfindliche Schicht 32 hinein ausbreitet (Fig. 7).

Ein derartiges Laserstrahlungsfeld 104 breitet sich bei geringer Leistungsdichte in der lichtempfindlichen Schicht 32 mit einer Ausdehnung aus, die wesentlich größer als der Fokus 100 ist, von welchem das Laserstrahlungsfeld 104 ausgeht, wie in Fig. 7 dargestellt. Insbesondere führt ein zunehmendes Eindringen des Laserstrahlungsfeldes 104 in die lichtempfindliche Schicht 32 zu einer zunehmenden Vergrößerung des dabei entstehenden Umwandlungsbereichs 34, insbesondere im Hinblick auf die Ausdehnung des dabei erzeugten Belichtungsflecks 30, die unmittelbar an einer Oberfläche 108 der lichtempfindlichen Schicht 32 am größten ist.

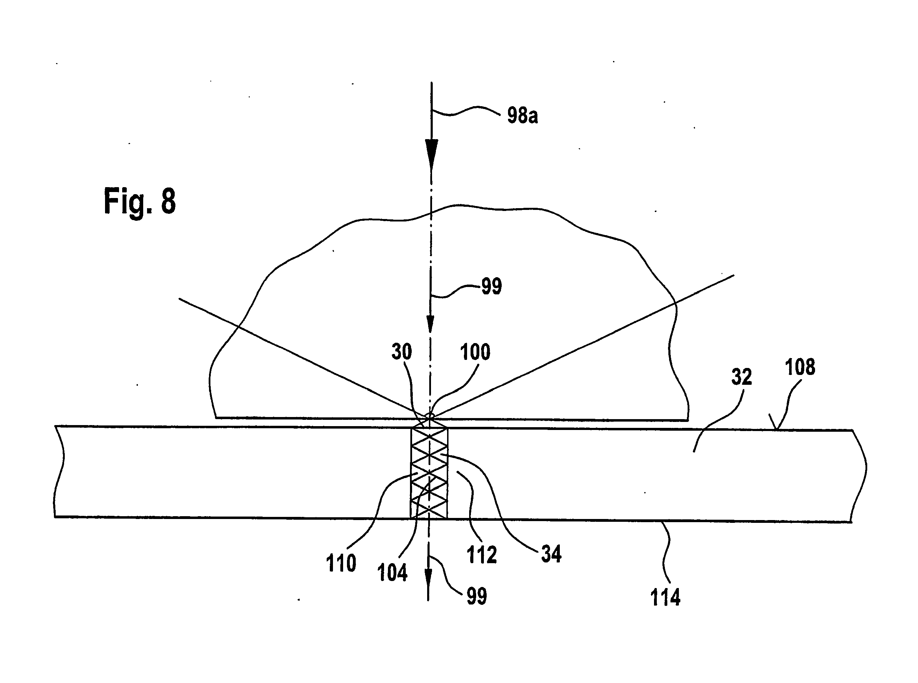

Aus diesem Grund ist, wie in Fig. 8 dargestellt, bei der erfindungsgemäßen Lösung vorgesehen, daß die Leistungsdichte des von jedem Fokus 100 ausgehenden Laserstrahlungsfeldes 104 in der lichtempfindlichen Schicht im Bereich von ungefähr $10^6$ bis ungefähr $10^8$ W/cm$^2$ liegt, so daß sich bedingt durch den Kerreffekt der Brechungsindex n innerhalb eines Kanals 110 der lichtempfindlichen Schicht 32 um mehr als 0,1, vorzugsweise mindestens 0,2 erhöht und aufgrund des innerhalb des Kanals 110 in der lichtempfindlichen Schicht 32 gegenüber einer Umgebung 112 erhöhten Brechungsindex n eine Reflexion des Laserstrahlungsfeldes 104 eintritt und somit das Laserstrahlungsfeld 104 innerhalb des Kanals 110 durch Reflexion am Übergang vom höheren Brechungsindex zum niedrigeren Brechungsindex geführt wird und damit mit einem im wesentlichen konstanten Querschnitt des Kanals 110 von der Oberfläche der lichtempfindlichen Schicht 32 weg in diese eindringt und diese vorzugsweise bis zu einem die lichtempfindliche Schicht 32 durchsetzenden Substrat 114 durchdringt.

Die Ausdehnung des Belichtungsflecks 30 entspricht dabei ungefähr einer Querschnittsfläche des sich in der lichtempfindlichen Schicht 32 ausbildenden Kanals 110 quer zu der Ausbreitungsrichtung 99 der Laserstrahlung 98.

Somit ist die Ausdehnung des Belichtungsflecks 30 und des sich an diesen anschließenden Umwandlungsbereichs 34 quer zur Ausbreitungsrichtung 99 der Laserstrahlung 98 aufgrund des Kerreffekts reduziert.

Eine weitere Reduzierung der Ausdehnung des Belichtungsflecks 30 läßt sich durch Verwendung einer TM 00-Welle für die Laserstrahlung 98 und Berücksichtigung einer durch die Polarisation festgelegten Ausrichtung des elektrischen Feldes E derselben erreichen.

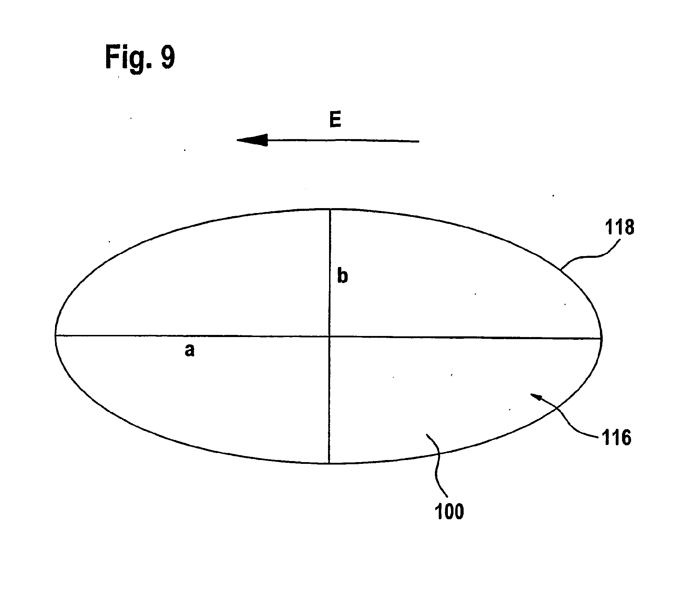

Wie in Fig. 9 dargestellt, ist die Intensitätsverteilung 116 der Laserstrahlung 98 im Fall einer TM 00-Welle in einer zur Ausbreitungsrichtung 99 senkrechten Ebene asymmetrisch, vorzugsweise elliptisch, und weist im Fall polarisierter Laserstrahlung in Richtung parallel zum elektrischen Feld E einen Durchmesser a auf, der größer ist als ein Durchmesser b senkrecht zum elektrischen Feld E, so daß die Intensitätsverteilung 116 näherungsweise elliptisch ist, wie durch eine elliptische Außenkontur 118 in Fig. 9 dargestellt.

Der Durchmesser a der Intensitätsverteilung 116 entspricht dabei ungefähr

$$a = 0{,}6\ \frac{\lambda}{NA},$$

das heißt er ist von der Wellenlänge λ der Laserstrahlung 98 und der numerischen Apertur NA der Fokussierungsoptik 24 abhängig.

Um nun zu erreichen, dass die Belichtungsflecken 30 in einer quer oder senkrecht zur Ausbreitungsrichtung 99 verlaufenden Ebene eine möglichst geringe Ausdehnung aufweisen, besteht bei einem zweiten Ausführungsbeispiel der erfindungsgemäßen Lösung die Möglichkeit, das von dem Fokus 100 mit der Intensitätsverteilung 116 ausgehende Laserstrahlungsfeld 104 noch in seiner Ausdehnung in der senkrecht zur Ausbreitungsrichtung 99 verlaufende Ebene durch eine Blendenstruktur 120 auf eine Ausdehnung zu begrenzen, die geringer ist als die Wellenlänge der Laserstrahlung 98 selbst.

Beispielsweise weist die Blendenstruktur 120 eine Durchtrittsöffnung 122 auf, die in einer Längsrichtung 124 langgestreckt ist und deren parallel zur Längsrichtung 124 verlaufende Längskanten 126a und 126b einen Abstand Ab voneinander aufweisen, der kleiner ist als die Wellenlänge R, vorzugsweise kleiner ist als zwei Drittel der Wellenlänge und insbesondere in der Größenordnung einer halben Wellenlänge λ der Laserstrahlung 98 liegt.

Ferner ist der Durchbruch 122 noch durch Querseitenkanten 128a und 128b begrenzt, welche in der Längsrichtung 124 im Abstand voneinander angeordnet sind und dieser Abstand ist größer als die Wellenlänge λ der Laserstrahlung 98, vorzugsweise beträgt er ein mehrfaches der Wellenlänge λ der Laserstrahlung 98.

Wird nun die Blendenstruktur 120 so ausgerichtet, dass das elektrische Feld E quer zu den Längsseitenkanten 126a, 126b der Durchtrittsöffnung 122 und somit quer zur Längsrichtung 124 der Durchtrittsöffnung 122 verläuft, so lässt sich das durch die Durchtrittsöffnung 122 hindurchtretende Laserstrahlungsfeld 104 in einer senkrecht zur Längsrichtung 124 verlaufenden Querrichtung 125 begrenzen, und zwar auf eine Ausdehnung, die ungefähr dem Abstand Ab zwischen den Längsseitenkanten 126a und 126b der Durchtrittsöffnung 122 entspricht.

Im vorteilhaftesten Fall ist das elektrische Feld E des Laserstrahlungsfeldes 104 so ausgerichtet, dass dieses senkrecht zu den Längsseitenkanten 126a und 126b steht, denn in einem derartigen Fall hat das durch die Durchtrittsöffnung 122 hindurch sich ausbreitende Laserstrahlungsfeld 104 die maximale Intensität.

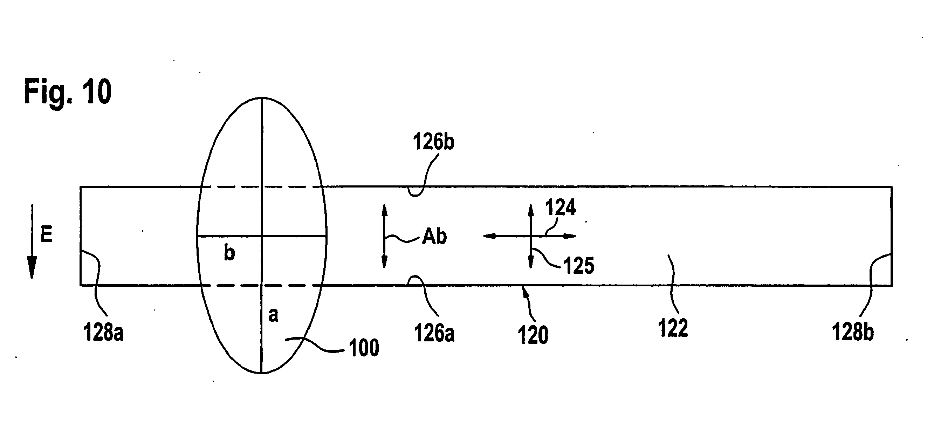

In diesem Fall verläuft, wie in Fig. 10 dargestellt, der Durchmesser a senkrecht zu den Längsseitenkanten 126a, 126b und der Durchmesser b parallel zu den Längsseitenkanten 126a, 126b der Durchtrittsöffnung 122.

Das austretende Laserstrahlungsfeld 104 hat damit In der Querrichtung 125 eine Ausdehnung die dem Abstand Ab zwischen den Längsseitenkanten 126a und 126b entspricht und in der Längsrichtung 124 eine Ausdehnung, die dem Durchmesser b der Intensitätsverteilung 116 entspricht, da in dieser Richtung die Blendenstruktur 120 unwirksam ist.

Vorzugsweise wird der Abstand Ab zwischen den Längsseitenkanten 126a, 126b so gewählt, dass dieser ungefähr dem Durchmesser b der Intensitätsverteilung 116 entspricht und somit insgesamt der entstehende Brennfleck 30 in jeder Richtung in einer senkrecht zur Ausbreitungsrichtung 99 verlaufenden Ebene eine näherungsweise ungefähr dieselbe Ausdehnung aufweist.

Weist die Blendenstruktur 120 einen über die gesamte Längsrichtung 124 im wesentlichen gleich breite Durchtrittsöffnung 122 auf, so tritt das Laserstrahlungsfeld 104 an jeder Stelle der Längsrichtung 124 mit derselben Intensität hindurch, so lange sich die Ausrichtung des elektrischen Feldes E senkrecht zu den Längsseitenkanten 126a, 126b nicht ändert. Wird die Ausrichtung des elektrischen Feldes E aus einer senkrecht zu den Längsseitenkanten 126a, 126b stehenden Stellung herausgedreht und weist mit den Längsseitenkanten 126a, 126b einen Winkel kleiner 90° auf, so wird die Intensität reduziert, da dann nur der Anteil des Laserstrahlungsfeldes 104 hindurchtritt, da dann nur der sich durch vektorielle Zerlegung ergebende Anteil der Laserstrahlung mit einem elektrischen Feld senkrecht zu den Längsseitenkanten 126a, 126b durch die Durchtrittsöffnung 122 hindurchtritt.

Im Fall einer Ausrichtung des elektrischen Feldes E parallel zu den Längsseitenkanten 126a, 126b tritt im wesentlichen kein Feld 104 durch die Durchtrittsöffnung 122 hindurch.

Eine derartige Blendenstruktur 120 mit der Durchtrittsöffnung 122 läßt sich vorzugsweise auf der Endfläche 102 der Endlinse 96 auftragen, beispielsweise durch Aufdampfen eines die Durchtrittsöffnung 122 nicht bedeckenden Films, beispielsweise eines Metallfilms 130, der bei dem ersten Ausführungsbeispiel unmittelbar auf die Endfläche 102 aufgetragen ist.

Die Blendenstruktur 120 kann eine derartige Ausdehnung in ihrer Längsrichtung 124 aufweisen kann, daß diese für die Foki der Laserstrahlung 40 mehrerer Laserstrahlungsquellen 26 begrenzend wirkt.

Die Längsrichtung 124 muß dabei parallel zur Ablenkrichtung 44 verlaufen, so daß jeder innerhalb eines der Streifenbereiche 52 erzeugte Belichtungsfleck 30 in gleicher Weise durch die Blendenstruktur 120 begrenzt ist.

Alternativ dazu ist es aber auch denkbar, für das Laserstrahlungsfeld 104 jeder einzelnen Laserstrahlungsquelle 26 eine separate Blendenstruktur 120 vorzusehen.

Bei der erfindungsgemäßen Lösung sind die Blendenstrukturen 120 so konzipiert, daß der Abstand Ab der Längsseitenkanten 126a, 126b im Fall blauer Laserstrahlung in der Dimension von kleiner als 400 Nanometer liegt, so daß auch die Belichtungsflecken 30 ungefähr entsprechende Dimensionen aufweist. Erreichbar sind damit Dimensionen der Belichtungsflecken 30 mit einem Durchmesser in jeder Richtung von weniger als 400 Nanometer, noch besser maximal 200 Nanometer, so daß mit der erfindungsgemäßen Lithografiebelichtungseinrichtung hoch aufgelöste belichtete Strukturen im Submikrometerbereich herstellbar sind.

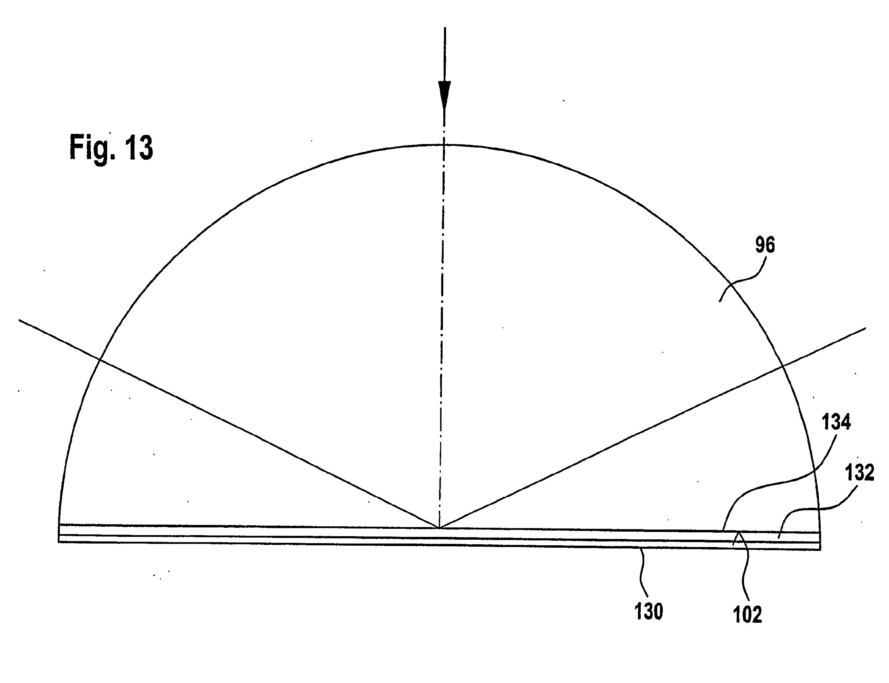

Alternativ zu dem zweiten Ausführungsbeispiel muß bei einem dritten Ausführungsbeispiel, dargestellt in Fig. 13 die die Blendenstruktur 120 bildende Beschichtung 130 nicht unmittelbar auf der Endfläche 102 der Endlinse 96 aufgetragen sein, sondern ist auf einem Träger 132 angeordnet, der seinerseits mit einer Flachseite 134 an der Endfläche 102 der Endlinse 96 anliegt und mit dieser brechungsindexangepaßt verbunden ist.

Eine derartige Verbindung unter Anpassung der Brechungsindizes zwischen der Endlinse 96 und dem Träger 132 erfolgt beispielsweise durch Verbinden des Trägers 132 mit der Endlinse 96 mittels Bonden, Ansprengen oder Kleben, insbesondere so, daß ein Brechungsindexgradient zwischen dem Material der Endlinse 96 und dem Material des Trägers 132 vermieden wird.

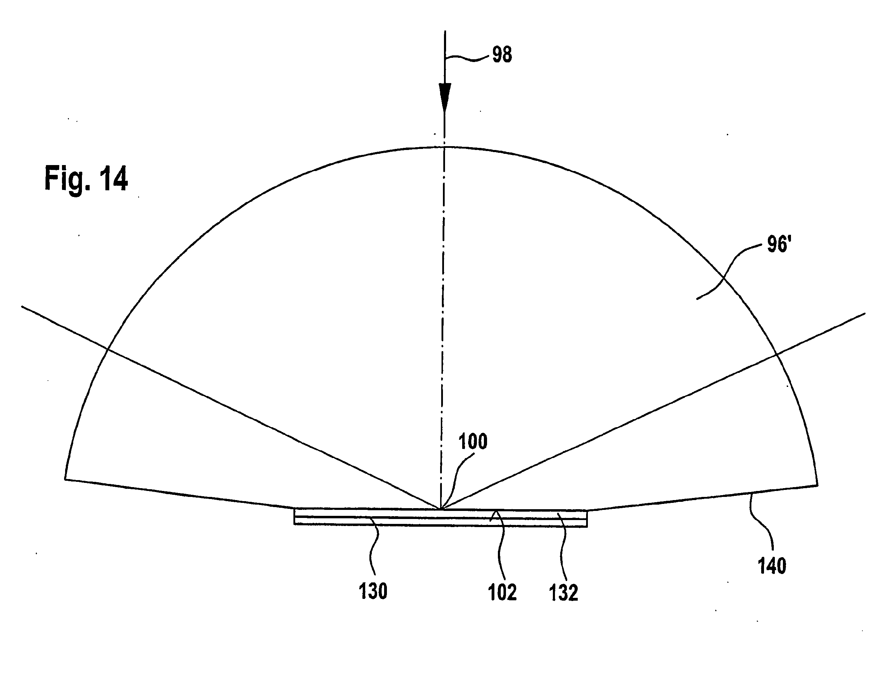

Bei einem vierten Ausführungsbeispiel, dargestellt in Fig. 14, erstreckt sich die Endfläche 102 der Endlinse 96' lediglich in einem zentralen Bereich derselben, nämlich in dem Bereich, in dem die Foki 100 liegen, während die Endlinse 96' in ihren der lichtempfindlichen Schicht 32 zugewandten und die Endfläche 102 umgebenden Außenbereichen 140 gegenüber der Endfläche 102 zurückgesetzt ist und somit einen größeren Abstand von der lichtempfindlichen Schicht 32 aufweist.

In diesem Fall ist auch der Träger 132 so ausgebildet, daß dieser nur an der Endfläche 102 der Endlinse 96' anliegt und mit dieser in der beschriebenen Art und Weise brechungsindexangepaßt verbunden ist.

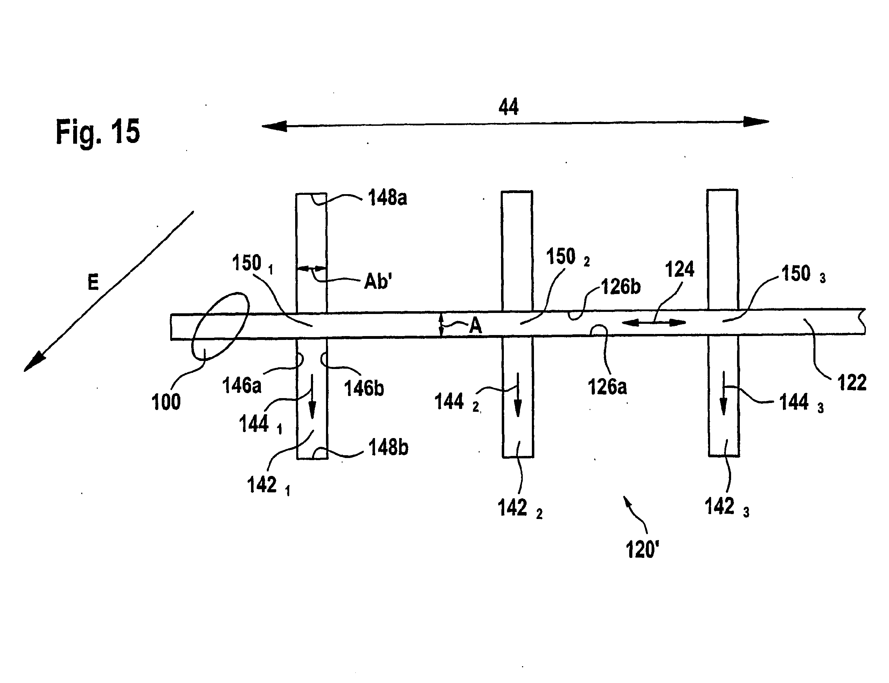

Bei einem fünften Ausführungsbeispiel, dargestellt in Fig. 15 ist die Blendenstruktur 120' so aufgebaut, daß diese zusätzlich zu der sich in der Längsrichtung 124 erstreckenden Durchtrittsöffnung 122 noch diese kreuzende Durchtrittsöffnungen 142$_1$, 142$_2$ und 142$_3$ oder gegebenenfalls noch mehr derartige kreuzende Durchtrittsöffnungen 142 umfaßt, die sich mit ihrer Längsrichtung 144$_1$, 144$_2$ und 144$_3$ senkrecht zur Längsrichtung 124 erstrecken und Längsseitenkanten 146a und 146b aufweisen, die ebenfalls in einem dem Abstand Ab ungefähr entsprechenden Abstand Ab' voneinander verlaufen, während Querseitenkanten 148a, 148b ebenfalls einen Abstand voneinander aufweisen, der wesentlich größer als die Wellenlänge ist.

Somit ergeben sich zwischen der Durchtrittsöffnung 122 und den Durchtrittsöffnungen 142 Kreuzungsstellen 150$_1$, 150$_2$ und 150$_3$.

Wird nun das elektrische Feld E des Laserstrahlungsfeldes 104 so ausgerichtet, daß dieses in einem Winkel von 45° zur Längsrichtung 124 und zu den Längsrichtungen 144 verläuft und verläuft die Ablenkrichtung 44 parallel zur Längsrichtung 124, so ist die Intensität des von einem Fokus 100 ausgehenden Laserstrahlungsfeldes 104 ungefähr die Hälfte der maximalen Intensität, so lang sich der Fokus über einem Bereich der Durchtrittsöffnung 122 außerhalb der Kreuzungsstellen 150 bewegt, da das elektrische Feld E aufgrund vektorieller Zerlegung senkrecht zur Längsrichtung 124 eine Komponente aufweist, die zur halben durch die Durchtrittsöffnung 122 hindurchtretenden Intensität führt.

Erreicht der Fokus 100 jedoch eine der Kreuzungsstellen 150, so tritt sowohl durch die Durchtrittsöffnung 122 als auch die jeweilige Durchtrittsöffnung 142 jeweils die halbe Intensität durch, so daß im Bereich der jeweiligen Kreuzungsstelle 150 die maximale Intensität des durch die Blendenstruktur 120' hindurchtretenden Laserstrahlungsfeldes 104 erreichbar ist.

Läßt sich dabei die Empfindlichkeit der lichtempfindlichen Schicht 132 so einstellen, daß bei halber maximaler Intensität des Laserstrahlungsfeldes 104 noch keine Umwandlung erfolgt, so ist lediglich an den Kreuzungsstellen 150 ein Belichtungsfleck 30 erzeugbar, der innerhalb des Umwandlungsbereichs 34 die lichtempfindliche Schicht umwandelt.

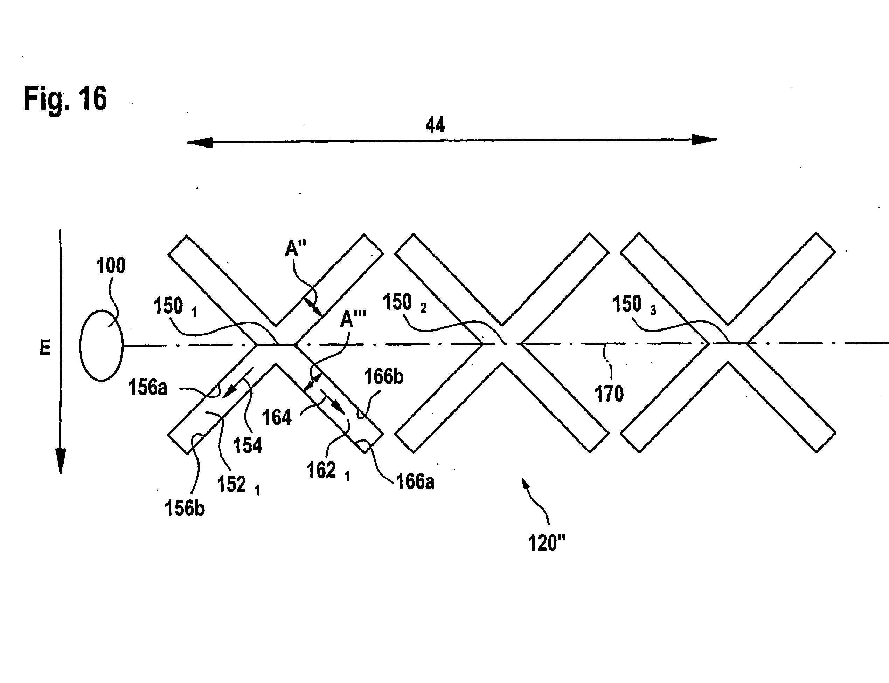

Bei einem sechsten Ausführungsbeispiel, dargestellt in der Fig. 16 ist die Blendenstruktur 120" ebenfalls so ausgebildet, dass sie Kreuzungsbereiche 150 umfasst, die in der Ablenkrichtung 44 aufeinanderfolgend angeordnet sind.

Diese Kreuzungsbereiche werden jedoch gebildet von langgezogenen Durchtrittsöffnungen 152, 162, die sich mit ihren Längsrichtungen 154, 164 senkrecht zueinander erstrecken und Längsseitenkanten 156a, b sowie 166a, b aufweisen, die in einem Abstand Ab" bzw. Ab"' voneinander angeordnet sind, der wie bei den vorangegangenen Ausführungsbeispielen kleiner als die Wellenlänge R der Laserstrahlung 98 ist. Da die Längsrichtungen 154 und 164 jeweils im Winkel von 45° zur Ablenkrichtung verlaufen, führt die Bewegung eines Fokus 100, dessen elektrisches Feld E senkrecht zur Ablenkrichtung 44 ausgerichtet ist, auf einer die Kreuzungsbereiche 150 schneidenden Bahn 170 dazu, dass der Fokus 100 jeweils nur in den Kreuzungsbereichen 150 die Durchtrittsöffnungen 152, 162 überdeckend angeordnet ist und somit kann sich nur dann, wenn der Fokus 100 über den jeweiligen Kreuzungsbereichen 150 steht, das Feld 104 ausbilden, dessen Intensität der maximalen Intensität entspricht, wie im Zusammenhang mit den Kreuzungsbereichen 150 beim fünften Ausführungsbeispiel erläutert.

Somit können nur im Bereich der Durchtrittsöffnungen 150 Belichtungsflecken 30 auf der lichtempfindlichen Schicht 32 erzeugt werden, die in der lichtempfindlichen Schicht auch zu einer entsprechenden Umwandlung derselben innerhalb eines jeweiligen Umwandlungsbereichs 34 führen.

**Patentansprüche**

1. Lithografiebelichtungseinrichtung zum Herstellen von sich in einer Fläche erstreckenden belichteten Strukturen (36) in einer lichtempfindlichen Schicht (32), mit einer Aufnahme (14) für die lichtempfindliche Schicht (32), mit einer Belichtungseinheit (18) umfassend mehrere Laserstrahlungsquellen (26), eine den Laserstrahlungsquellen (26) zugeordnete Fokussierungsoptik (24) für die aus den jeweiligen Laserstrahlungsquellen (26) austretende Laserstrahlung (40), welche aus der Laserstrahlung (40) jeder der Laserstrahlungsquellen (26) einen in der lichtempfindlichen Schicht (32) wirksamen Belichtungsfleck (30) mit einer festgelegten Ausdehnung (A) quer zu einer Belichtungsbewegungsrichtung (50) erzeugt, mit einer Bewegungseinheit zur Erzeugung einer Relativbewegung zwischen der Fokussierungsoptik (24) und der Aufnahme (14) in der Belichtungsbewegungsrichtung (50) und mit einer Steuerung (160) zur Steuerung von Intensität und Lage der Belichtungsflecken (30) relativ zur lichtempfindlichen Schicht (32) derart, dass mittels der Belichtungsflecken (30) eine Vielzahl von in die lichtempfindliche Schicht (32) eindringenden Umwandlungsbereichen (34) erzeugbar ist, in denen das Material der lichtempfindlichen Schicht (32) von einem Ausgangszustand in den belichteten Zustand umgewandelt ist, und die zusammen die belichtete Struktur (36) ergeben,
**dadurch gekennzeichnet, dass** die Fokussierungsoptik (24) eine Endlinse (96) aufweist, die nahe der lichtempfindlichen Schicht (32) Foki (100) der aus jeder der Laserstrahlungsquellen (26) austretenden Laserstrahlung (40) erzeugt, dass sich zur Erzeugung der Belichtungsflecken (30) von den Foki (100) jeweils ein Laserstrahlungsfeld (104) in Richtung der lichtempfindlichen Schicht (32) ausbreitet und eine Leistungsdichte aufweist, welche in dem Umwandlungsbereich (34) in der lichtempfindlichen Schicht (32) zur Ausbildung eines in die lichtempfindliche Schicht (32) eindringenden Kanals (110) mit durch den Kerreffekt gegenüber seiner Umgebung (112) erhöhtem Brechungsindex führt, der das jeweilige Laserstrahlungsfeld (104) räumlich begrenzt führt.

2. Lithografiebelichtungseinrichtung nach Anspruch 1, **dadurch gekennzeichnet, dass** die Leistungsdichte des Laserstrahlungsfeides (104) im Umwandlungsbereich (34) in einem Bereich von ungefähr $10^6$ bis ungefähr $10^8$ W/cm$^2$ liegt.

3. Lithografiebelichtungseinrichtung nach Anspruch 1 oder 2, **dadurch gekennzeichnet, dass** das jeweilige Laserstrahlungsfeld (104) durch leistungsüberhöhte Kurzpulse gebildet ist.

4. Lithografiebelichtungseinrichtung nach Anspruch 3, **dadurch gekennzeichnet, dass** die Kurzpulse eine Pulsdauer im Bereich von wenigen Nanosekunden oder noch kürzer aufweisen.

5. Lithografiebelichtungseinrichtung nach einem der voranstehenden Ansprüche, **dadurch gekennzeichnet, dass** der Kerreffekt in dem Kanal (110) zu einer Erhöhung des Brechungsindex gegenüber der Umgebung (112) in der lichtempfindlichen Schicht (32) um mehr als 0,1 führt.

6. Lithograftebelichtungseinrichtung nach einem der voranstehenden Ansprüche, **dadurch gekennzeichnet, dass** der Kanal (110) quer zur Ausbreitungsrichtung (99) eine Querschnittsfläche aufweist, die maximal der Ausdehnung des entsprechenden Fokus (100) in der Endfläche (102) entspricht.

7. Lithografebelichtungseinrichtung nach einem der voranstehenden Ansprüche, **dadurch gekennzeichnet, dass** die Endlinse (96) nahe oder in Ihrer der lichtempflindlichen Schicht (32) zugewandten Endfläche (102) die Foki (100) der Laserstrahlung (40) erzeugt.

8. Lithografiebelichtungseinrichtung nach einem der voranstehenden Ansprüche, **dadurch gekennzeichnet, dass** die Endfläche (102) der Endlinse (96) in einem von der Laserstrahlung (40) durchsetzten Bereich eben ist.

9. Lithografiebelichtungseinrichtung nach einem der voranstehenden Ansprüche, **dadurch gekennzeichnet, dass** die Endlinse (96) ähnlich einer Hemisphäre oder eine Hyperhemisphäre geformt ist.

10. Lithografiebelichtungseinrichtung nach einem der voranstehenden Ansprüche, **dadurch gekennzeichnet, dass** die Foki (100) im Festkörper der Endlinse (96) und in einem an deren Endfläche (102) angrenzenden Bereich liegen.

11. Lithografiebelichtungseinrichtung nach einem der voranstehenden Ansprüche, **dadurch gekennzeichnet, dass** die Endlinse (96) mit ihrer Endfläche (102) in einem Abstand von der lichtempfindlichen Schicht (32) angeordnet ist, der kleiner ist als die Hälfte der Lichtwellenlänge der Laserstrahlung im Vakuum.

12. Lithografiebelichtungseinnchtung nach Anspruch 11, **dadurch gekennzeichnet, dass** der Abstand weniger als ungefähr 50 Nanometer Beträgt.

13. Lithografiebelichtungseinrichtung nach einem der voranstehenden Ansprüche, **dadurch gekennzeichnet, dass** die lichtempfindliche Schicht (32) eine Fotolackschicht ist.

14. Lithografiebelichtungseinrichtung nach einem der voranstehenden Ansprüche, **dadurch gekennzeichnet, dass** der lichtempfindlichen Schicht (32) zugewandten Endfläche (102) der Fokussierungsoptik (24) eine die räumliche Ausdehnung der Belichtungsflecken (30) auf Dimensionen im Bereich der Wellenlänge der Laserstrahlung (40) oder kleinere Dimensionen reduzierende Blendenstruktur (120) zugeordnet ist.

15. Lithografiebelichtungseinrichtung nach Anspruch 14, **dadurch gekennzeichnet, dass** die Blendenstruktur (120) das jeweilige Laserstrahlungsfeld (98) in Richtung einer Komponenten von dessen elektrischem Feld (E) begrenzt.

16. Lithografiebelichtungseinrichtung nach Anspruch 14 oder 15, **dadurch gekennzeichnet, dass** die Blendenstruktur (120) mindestens eine sich in einer Längsrichtung (124, 144, 154, 164) über mehr als eine Wellenlänge (R) der Laserstrahlung (98) erstreckende Durchtrittsöffnung (122, 142, 152, 162) aufweist.

17. Lithografiebelichtungseinrichtung nach Anspruch 16, **dadurch gekennzeichnet, dass** die Durchtrittsöffnung (122, 142, 152, 162) Längsseitenkanten (126, 146, 156, 166) aufweist, die voneinander einen Abstand (Ab) von einer Wellenlänge der Laserstrahlung (98) oder weniger aufweisen.

18. Lithografiebelichtungseinrichtung nach einem der voranstehenden Ansprüche, **dadurch gekennzeichnet, dass** jeder Belichtungsfleck (30) in einer quer zur Belichtungsbewegungsrichtung (50) verlaufenden Ablenkrichtung (44) bewegbar ist.

19. Lithografiebelichtungseinrichtung nach Anspruch 18, **dadurch gekennzeichnet, dass** sich mindestens eine der Durchtrittsöffnungen (122) der Blendenstruktur (120) in der Ablenkrichtung (44) erstreckt.

20. Lithografiebelichtungseinrichtung nach einem der Ansprüche 16 bis 19, **dadurch gekennzeichnet, dass** die Blendenstruktur (120) eine sich mindestens über einen Bewegungsbereich des jeweiligen Belichtungsffecks (30) in der Ablenkrichtung (44) erstreckende Durchtrittsöffnung (122) aufweist.

21. Lithagrafiebelichtungseinrichtung nach einem der Ansprüche 16 bis 20, **dadurch gekennzeichnet, dass** die Blendenstruktur (120', 120") in der Ablenkrichtung (44) aufeinanderfolgende Durchlassstellen (150) für das Laserstrahlungsfeld (98) aufweist.

22. Lithografiebelichtungseinrichtung nach Anspruch 21, **dadurch gekennzeichnet, dass** die Durchlassstellen (150) durch Kreuzungsstellen zweier schlitzförmiger Durchtrittsöffnungen (122, 142, 152, 162) gebildet sind.

23. Lithografiebelichtungseinrichtung nach Anspruch 22, **dadurch gekennzeichnet, dass** eine der schlitzförmigen Durchtrittsöffnungen (120) sich in der Ablenkrichtung (44) durch die Durchlassstellen (150) hindurch erstreckt.

24. Lithografiebelichtungseinrichtung nach Anspruch 23, **dadurch gekennzeichnet, dass** sich die in der Ablenkrichtung (44) erstreckende schlitzförmige Durchtrittsöffnung (122) über den gesamten Bewegungsbereich des jeweiligen Laserstrahlungsfeldes (98) in der Ablenkrichtung (44) erstreckt.

25. Lithografiebelichtungseinrichtung nach einem der Ansprüche 16 bis 22, **dadurch gekennzeichnet, dass** sich die Durchtrittsöffnungen (152, 162) schräg zur Ablenkrichtung (44) erstrecken.

26. Lithografrebelichtungseinrichtung nach einem der Ansprüche 16 bis 25, **dadurch gekennzeichnet, dass** das elektrische Feld (E) der jeweiligen Laserstrahlung (98) quer zur Längsrichtung (124, 144, 154, 164) der jeweiligen Durchtrittsöffnungen (122, 142, 152, 162) erstreckt.

27. Lithografiebelichtungseinrichtung nach einem der Ansprüche 14 bis 26, **dadurch gekennzeichnet, dass** die Blendenstruktur (120) unmittelbar auf der Endfläche (102) der Endlinse (96) angeordnet ist.

28. Lithografebeliehtungseinrichtung nach einem der Ansprüche 14 bis 26, **dadurch gekennzeichnet, dass** die Blendenstruktur (120) auf einem Träger (132) angeordnet ist, der seinerseits an der Endfläche (102) der Endlinse (96) anliegt.

29. Lithografebelichtungseinrichtung nach Anspruch 28, **dadurch gekennzeichnet, dass** der Träger (132) mit einer der Blendenstruktur (120) gegenüberliegenden Seite an der Endfläche (102) der Endlinse (96) angeordnet ist.

30. Lithografiebelichtungseinrichtung nach Anspruch 28 oder 29, **dadurch gekennzeichnet, dass** der Träger (132) brechungsindexangepasst mit der Endfläche (102) der Endlinse (96) verbunden ist.

31. Lithografiebelichtungseinrichtung nach einem der Ansprüche 28 bis 30, **dadurch gekennzeichnet, dass** der Träger (132) klebstofffrei mit der Endfläche (102) der Endlinse (96) verbunden ist.

32. LIthografiebelichtungseinrichtung nach einem der Ansprüche 14 bis 31, **dadurch gekennzeichnet, dass** die Blendenstruktur (120) durch eine Metallschicht (130) gebildet ist.

**Claims**

1. Lithography exposure device for producing exposed structures (36) extending in a surface area in a light-sensitive layer (32), comprising a mounting device (14) for the light-sensitive layer (32), an exposure unit (18) comprising several laser radiation sources (26), an optical focusing means (24) associated with the laser radiation sources (26) for the laser radiation (40) exiting from the respective laser radiation sources (26), the optical focusing means generating from the laser radiation (40) of each of the laser radiation sources (26) an exposure spot (30) effective in the light-sensitive layer (32) with a predetermined extension (A) transverse to a direction of exposure movement (50), a movement unit for generating a relative movement between the optical focusing means (24) and the mounting device (14) in the direction of exposure movement (50) and a control (160) for controlling intensity and position of the exposure spots (30) relative to the light-sensitive layer (32) in such a manner that a plurality of conversion areas (34) penetrating the light-sensitive layer (32) are generatable by means of the exposure spots (30), the material of the light-sensitive layer (32) being converted in said conversion areas from an initial state into the exposed state, and said conversion areas together resulting in the exposed structure (36), **characterized in that** the optical focusing means (24) has an end lens (96) generating focal points (100) of the laser radiation (40) exiting from each of the laser radiation sources (26) close to the light-sensitive layer (32), **in that** a respective laser radiation field (104) propagates from the focal points (100) in the direction of the light-sensitive layer (32) for generation of the exposure spots (30) and has a power density leading in the conversion area (34) in the light-sensitive layer (32) to the formation of a channel (110) which penetrates the light-sensitive layer (32) with an index of refraction increased in relation to its surroundings (112) by the Kerr effect and guides the respective laser radiation field (104) in a spatially limited manner.

2. Lithography exposure device in accordance with claim 1, **characterized in that** the power density of the laser radiation field (104) in the conversion area (34) is in a range of approximately $10^6$ to approximately $10^8$ W/cm$^2$.

3. Lithography exposure device in accordance with claim 1 or 2, **characterized in that** the respective laser radiation field (104) is formed by short pulses with excessive power.

4. Lithography exposure device in accordance with claim 3, **characterized in that** the short pulses have a pulse duration in the range of a few nanoseconds or even shorter.

5. Lithography exposure device in accordance with any one of the preceding claims, **characterized in that** the Kerr effect leads in the channel (110) to an increase in the index of refraction in relation to the surroundings (112) in the light-sensitive layer (32) by more than 0.1.

6. Lithography exposure device in accordance with any one of the preceding claims, **characterized in that** the channel (110) has transversely to the direction of propagation (99) a cross-sectional surface area corresponding at the most to the extent of the corresponding focal point (100) in the end surface (102).

7. Lithography exposure device in accordance with any one of the preceding claims, **characterized in that** the end lens (96) generates the focal points (100) of the laser radiation (40) close to or in its end surface (102) facing the light-sensitive layer (32).

8. Lithography exposure device in accordance with any one of the preceding claims, **characterized in that** the end surface (102) of the end lens (96) is flat in an area penetrated by the laser radiation (40).

9. Lithography exposure device in accordance with any one of the preceding claims, **characterized in that** the end lens (96) is shaped in a similar manner to a hemisphere or a hyperhemisphere.

10. Lithography exposure device in accordance with any one of the preceding claims, **characterized in that** the focal points (100) are located in the solid-state body of the end lens (96) and in an area bordering on its end surface (102).

11. Lithography exposure device in accordance with any one of the preceding claims, **characterized in that** the end lens (96) is arranged with its end surface (102) at a distance from the light-sensitive layer (32) smaller than half the length of the light wave of the laser radiation in a vacuum.

12. Lithography exposure device in accordance with claim 11, **characterized in that** the distance is less than approximately 50 nanometers.

13. Lithography exposure device in accordance with any one of the preceding claims, **characterized in that** the light-sensitive layer (32) is a photosensitive coating layer.

14. Lithography exposure device in accordance with any one of the preceding claims, **characterized in that** a diaphragm structure (120) reducing the spatial extent of the exposure spots (30) to dimensions in the range of the wavelength of the laser radiation (40) or to smaller dimensions is associated with the end surface (102) of the optical focusing means (24) facing the light-sensitive layer (32).

15. Lithography exposure device in accordance with claim 14, **characterized in that** the diaphragm structure (120) limits the respective laser radiation field (98) in the direction of a component of its electric field (E).

16. Lithography exposure device in accordance with claim 14 or 15, **characterized in that** the diaphragm structure (120) has at least one opening (122, 142, 152, 162) extending in a longitudinal direction (124, 144, 154, 164) over more than one wavelength (R) of the laser radiation (98).

**17.** Lithography exposure device in accordance with claim 16, **characterized in that** the opening (122, 142, 152, 162) has longitudinal side edges (126, 146, 156, 166) having a distance (Ab) from one another of a wavelength of the laser radiation (98) or less.

**18.** Lithography exposure device in accordance with any one of the preceding claims, **characterized in that** each exposure spot (30) is movable in a direction (44) of deflection extending transversely to the direction of exposure movement (50).

**19.** Lithography exposure device in accordance with claim 18, **characterized in that** at least one of the openings (122) of the diaphragm structure (120) extends in the direction of deflection (44).

**20.** Lithography exposure device in accordance with any one of claims 16 to 19, **characterized in that** the diaphragm structure (120) has an opening (122) extending at least over an area of movement of the respective exposure spot (30) in the direction of deflection (44).

**21.** Lithography exposure device in accordance with any one of claims 16 to 20, **characterized in that** the diaphragm structure (120', 120") has in the direction of deflection (44) consecutive passage areas (150) for the laser radiation field (98).

**22.** Lithography exposure device in accordance with claim 21, **characterized in that** the passage areas (150) are formed by intersecting areas of two slit-shaped openings (122, 142, 152, 162).

**23.** Lithography exposure device in accordance with claim 22, **characterized in that** one of the slit-shaped openings (120) extends through the passage areas (150) in the direction of deflection (44).

**24.** Lithography exposure device in accordance with claim 23, **characterized in that** the slit-shaped opening (122) extending in the direction of deflection (44) extends over the entire area of movement of the respective laser radiation field (98) in the direction of deflection (44).

**25.** Lithography exposure device in accordance with any one of claims 16 to 22, **characterized in that** the openings (152, 162) extend at an angle to the direction of deflection (44).

**26.** Lithography exposure device in accordance with any one of claims 16 to 25, **characterized in that** the electric field (E) of the respective laser radiation (98) extends transversely to the longitudinal direction (124, 144, 154, 164) of the respective openings (122, 142, 152, 162).

**27.** Lithography exposure device in accordance with any one of claims 14 to 26, **characterized in that** the diaphragm structure (120) is arranged directly on the end surface (102) of the end lens (96).

**28.** Lithography exposure device in accordance with any one of claims 14 to 26, **characterized in that** the diaphragm structure (120) is arranged on a carrier (132) abutting for its part on the end surface (102) of the end lens (96).

**29.** Lithography exposure device in accordance with claim 28, **characterized in that** the carrier (132) is arranged on the end surface (102) of the end lens (96) with a side located opposite the diaphragm structure (120).

**30.** Lithography exposure device in accordance with claim 28 or 29, **characterized in that** the carrier (132) is connected to the end surface (102) of the end lens (96) in a manner adapted with respect to the index of refraction.

**31.** Lithography exposure device in accordance with any one of claims 28 to 30, **characterized in that** the carrier (132) is connected to the end surface (102) of the end lens (96) free from adhesive.

**32.** Lithography exposure device in accordance with any one of claims 14 to 31, **characterized in that** the diaphragm structure (120) is formed by a metal layer (130).

**Revendications**

**1.** Dispositif d'éclairage par une lithographie destiné à la fabrication de structures (36) exposées à la lumière, lesquelles s'étendent dans une surface dans une couche sensible à la lumière, lequel dispositif comportant :

> - une réception (14) pour la couche (32) sensible à la lumière,
> - une unité d'exposition à la lumière (18) comprenant plusieurs sources de rayonnement laser (26), une optique de focalisation (24) associée auxdites sources de rayonnement laser (26) et destinée au rayonnement laser (40) sortant des sources de rayonnement laser (26) respectifs, laquelle optique de focalisation génère, à partir du rayonnement laser (40) de chacune des sources de rayonnement laser (26), une tâche (30) générée par l'exposition à la lumière qui est active dans la couche (32) sensible à la lumière et qui présente une extension (A) déterminée dans une direction transversale par rapport à une direction (50) d'exposition à la lumière,
- une unité de déplacement destinée à générer un mouvement entre l'optique de focalisation (24) et la réception (14), dans la direction d'exposition à la lumière (50) et,
- une unité de commande (160) destinée à commander l'intensité et la position des tâches générées par l'exposition à la lumière (30) par rapport à la couche (32) sensible à la lumière afin de générer une multitude de zones de transformation (34) pénétrant dans la couche (32) sensible à la lumière, dans lesquelles zones le matériau de la couche (32) sensible à la lumière passe d'un état de départ vers un état d'exposition à la lumière ; lesquelles zones d'exposition à la lumière formant la structure (36) d'exposition à la lumière,

**caractérisé en ce que** l'optique de focalisation (24) comporte une lentille terminale (96) qui génère près de la couche (32) sensible à la lumière, des foyers (100) de rayonnement laser (40) émanant de chacune des sources (26) de rayonnement laser, **en ce que** pour générer les tâches (30) générées par l'exposition à la lumière un champ de rayonnement laser (104) se propage à chaque fois des foyers (100) en direction de la couche (32) sensible à la lumière, et présente une densité d'intensité qui aboutit dans la zone de transformation (34) située dans la couche (32) sensible à la lumière, à la formation d'un canal (110) pénétrant dans la couche (32) sensible à la lumière ayant un indice de réfraction supérieur à son environnement (112) grâce à l'effet Kerr, lequel canal conduit le champ de rayonnement respectif (104) limité dans un espace limité.

2. Dispositif d'éclairage par une lithographie selon la revendication 1, **caractérisé en ce que** la densité d'intensité du champ de rayonnement laser (104) se situe dans la zone de transformation (34), dans une zone comprise entre environ $10^6$ et environ $10^8$ W/cm2.

3. Dispositif d'éclairage par une lithographie selon la revendication 1, **caractérisé en ce que** le champ de rayonnement laser (104) respectif est formé par des impulsions courtes de puissance supérieure.

4. Dispositif d'éclairage par une lithographie selon la revendication 3, **caractérisé en ce que** les impulsions courtes présentent une durée d'impulsion inférieur à la nanoseconde ou d'une durée encore plus courte.

5. Dispositif d'éclairage par une lithographie selon une des revendications précédentes, **caractérisé en ce que** l'effet Kerr génère dans le canal (110) une augmentation de l'indice de réfraction par rapport à l'environnement (112) dans la couche (32) sensible à la lumière supérieure à 0,1.

6. Dispositif d'éclairage par une lithographie selon une des revendications précédentes , **caractérisé en ce que** le canal (110) présente une surface de section transversale qui s'étend de façon transversale par rapport à la direction de propagation (99), laquelle surface correspond au maximum à la dimension du foyer (100) respectif se trouvant dans la surface finale (102).

7. Dispositif d'éclairage par une lithographie selon une des revendications précédentes, **caractérisé en ce que** la lentille terminale (96) génère près de sa surface finale (102) orientée vers la couche (32) sensible à la lumière ou dans celle-ci, les foyers (100) du rayonnement laser (40).

8. Dispositif d'éclairage par une lithographie selon une des revendications précédentes, **caractérisé en ce que** la surface finale (102) de la lentille terminale (96) est plate dans une zone traversée par le rayonnement laser (40).

9. Dispositif d'éclairage par une lithographie selon une des revendications précédentes, **caractérisé en ce que** la lentille terminale (96) est réalisée sous une forme qui ressemble à une hémisphère ou à une hyperhémisphère.

10. Dispositif d'éclairage par une lithographie selon une des revendications précédentes, **caractérisé en ce que** les foyers (100) sont situés dans le corps solide de la lentille terminale (96) et dans une zone adjacente à la surface finale (102) de ladite lentille.

11. Dispositif d'éclairage par une lithographie selon une des revendications précédentes, **caractérisé en ce que** la surface finale (102) de la lentille terminale (96) est disposée à une certaine distance par rapport à la couche sensible à la lumière qui est inférieure à la moitié de la longueur d'onde de la lumière du rayonnement laser dans le vide.

12. Dispositif d'éclairage par une lithographie selon la revendication 11, **caractérisé en ce que** la distance est inférieure d'environ 50 nanomètres.

13. Dispositif d'éclairage par une lithographie selon une des revendications précédentes, **caractérisé en ce que** la couche (32) sensible à la lumière est une couche de photorésistant.

14. Dispositif d'éclairage par une lithographie selon une des revendications précédentes, **caractérisé en ce qu'**une structure de diaphragme (120) qui réduit la dimension des tâches (30) générées par l'exposition

à la lumière dans l'espace à des dimensions d'un ordre de grandeur correspondant à la longueur d'onde du rayonnement laser (40) ou à des dimensions inférieures, est associée à la surface finale (102) de l'optique de focalisation (24) orientée vers la couche sensible à la lumière (32).

**15.** Dispositif d'éclairage par une lithographie selon la revendication 14, **caractérisé en ce que** la structure de diaphragme (120) limite le champ de rayonnement laser (98) respectif dans la direction d'une composante du champ électrique (E) dudit champ de rayonnement laser.

**16.** Dispositif d'éclairage par une lithographie selon les revendications 14 ou 15, **caractérisé en ce que** la structure de diaphragme (120) présente une ouverture de passage qui s'étend dans une direction longitudinale (124, 144, 154, 164) sur plus d'une longueur d'onde (R) du rayonnement laser (98).

**17.** Dispositif d'éclairage par une lithographie selon la revendication 16, **caractérisé en ce que** l'ouverture de passage (122, 142, 152, 162) présente des bords situés sur les côtés longitudinaux (126, 146, 156, 166), lesquels bords présentent entre eux une distance (Ab) qui équivaut à une longueur d'onde du rayonnement laser (98) ou à moins .

**18.** Dispositif d'éclairage par une lithographie selon une des revendications précédentes, **caractérisé en ce que** chaque tâche générée par l'exposition à la lumière (30) peut être déplacée dans une direction (44) de déviation s'étendant de façon transversale par rapport à la direction (50) de déplacement de l'exposition à lumière.

**19.** Dispositif d'éclairage par une lithographie selon la revendication 18, **caractérisé en ce qu'**au moins une des ouvertures de passage (122) de la structure de diaphragme (120) s'étend dans la direction de déviation (44).

**20.** Dispositif d'éclairage par une lithographie selon une des revendications 16 à 19, **caractérisé en ce que** la structure de diaphragme (120) présente une ouverture de passage (122) qui s'étend sur au moins une zone de déplacement de la tâche d'exposition à la lumière respective (30) dans la direction (44) de déviation.

**21.** Dispositif d'éclairage par une lithographie selon une des revendications 16 à 20, **caractérisé en ce que** la structure de diaphragme (120', 120") présente des endroits de passage successifs (150) dans la direction de déviation (44) destinés au champ de rayonnement laser (98).

**22.** Dispositif d'éclairage par une lithographie selon la revendication 21, **caractérisé en ce que** les endroits de passage (150) sont formés par des endroits où se croisent deux ouvertures de passage (122, 142, 152, 162) en forme de fente.

**23.** Dispositif d'éclairage par une lithographie selon la revendication 22, **caractérisé en ce qu'**une des ouvertures de passage (120) en forme de fente, s'étend dans la direction de déviation (44) à travers les endroits de passage (150).

**24.** Dispositif d'éclairage par une lithographie selon la revendication 23, **caractérisé en ce que** l'ouverture de passage (122) en forme de fente qui s'étend dans la direction de déviation, s'étend sur toute la zone de déplacement du champ de rayonnement laser respectif (98) dans la direction de déviation (44).

**25.** Dispositif d'éclairage par une lithographie selon une des revendications 16 à 22, **caractérisé en ce que** les ouvertures de passage (152, 162) s'étendent en biais par rapport à la direction de déviation (44).

**26.** Dispositif d'éclairage par une lithographie selon une des revendications 16 à 25, **caractérisé en ce que** le champ électrique ( E ) du rayonnement laser (98) respectif s'étend de façon transversale par rapport à la direction longitudinale (124, 144, 154, 164) des ouvertures de passage (122, 142, 152, 162) respectives.

**27.** Dispositif d'éclairage par une lithographie selon une des revendications 14 à 26, **caractérisé en ce que** la structure de diaphragme (120) est disposée directement sur la surface finale (102) de la lentille terminale (96).

**28.** Dispositif d'éclairage par une lithographie selon une des revendications 14 à 26, **caractérisé en ce que** la structure de diaphragme (120) est disposée sur un support (132) qui s'appuie pour sa part sur la surface finale (102) de la lentille terminale (96).

**29.** Dispositif d'éclairage par une lithographie selon la revendication 28, **caractérisé en ce que** le support (132) est disposé sur la surface finale (102) de la lentille terminale (96) avec un côté situé à l'opposé à la structure du diaphragme (120).

**30.** Dispositif d'éclairage par une lithographie selon une des revendications 28 ou 29, **caractérisé en ce que** le support (132) est raccordé avec la surface finale (102) de la lentille terminale de façon à ce que les indices de réfraction du support et de la lentille soient mutuellement adaptés.

**31.** Dispositif d'éclairage par une lithographie selon une

des revendications 28 à 30, **caractérisé en ce que** le support (132) est raccordé sans colle avec la surface finale (102) de la lentille terminale (96).

32. Dispositif d'éclairage par une lithographie selon une des revendications 14 bis 31, **caractérisé en ce que** la structure de diaphragme (120) est formée par une couche métallique (130).

## Fig. 1

EP 1 668 422 B1

**Fig. 2**

18

EP 1 668 422 B1

# Fig. 3

19

# Fig. 4

$n_1$

60

40

$n_2$

64

φ

62

66

68

α

$n_1$

# Fig. 5

Fig. 6

Fig. 7

EP 1 668 422 B1

Fig. 8

EP 1 668 422 B1

# Fig. 9

# Fig. 10

EP 1 668 422 B1

**Fig. 11**

96

126b    122

126a    124

120

130

102

EP 1 668 422 B1

**Fig. 12**

EP 1 668 422 B1

130

102

Fig. 13

96

134

132

130

102

EP 1 668 422 B1

Fig. 14

EP 1 668 422 B1

Fig. 15

EP 1 668 422 B1

Fig. 16

EP 1 668 422 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1319984 A